# EUROPEAN PATENT APPLICATION

(11) **EP 4 380 339 A1**
(43) Date of publication of application: **05.06.2024**
(21) Application number: 23212236.6
(22) Date of filing: 27.11.2023
(51) Int. Cl.: H10K 59/12, H10K 77/10

(54) **BENDING AREA STRUCTURE OF DISPLAY APPARATUS AND METHOD OF PROVIDING THE SAME**

(30) Priority: 29.11.2022 KR 20220163248
(71) Applicant: Samsung Display Co., Ltd., Yongin-si, Gyeonggi-do 17113 (KR)
(72) Inventor: LEE, Donghyun, 17113 Yongin-si, Gyeonggi-do (KR); SONG, Sijoon, 17113 Yongin-si, Gyeonggi-do (KR); YOON, Sanghyuck, 17113 Yongin-si, Gyeonggi-do (KR); LEE, Junyoung, 17113 Yongin-si, Gyeonggi-do (KR)
(74) Representative: Gulde & Partner

(57) **Abstract**

A display apparatus (1) includes a display panel (10) including a display area (DA) and a bending area (BA) which is spaced apart from the display area (DA) and at which the display panel (10) is bendable to define a bent portion (700), and a cover window (CW) which is in the bending area (BA) and covers the display panel (10). The display panel (10) which is bent includes an adjacent portion (600) of the display panel (10) which is closer to the cover window (CW) than the bent portion (700), overlaps the bent portion (770) and is unbent.

## Description

### BACKGROUND

### 1. Field

One or more embodiments relate to a display apparatus and a method of manufacturing (or providing) the display apparatus. More particularly, one or more embodiments relate to a display apparatus with a bent portion and a method of manufacturing (or providing) the same.

### 2. Description of the Related Art

Electronic apparatuses are widely used. Electronic apparatuses are variously used as mobile electronic apparatuses and fixed electronic apparatuses. To support various functions, the electronic apparatus includes a display apparatus which may provide visual information such as images to users.

As the parts driving a display apparatus have been miniaturized, the proportion of the display apparatus including the driving parts in an electronic apparatus has gradually increased and a display apparatus structure that may be bent to a preset angle with respect to a flat state or folded around an axis with respect to the flat state is also under development.

### SUMMARY

A display apparatus includes a display panel. The display panel includes a display area and a peripheral area. The display area is configured to display images, and the peripheral area is a non-display area which is adjacent to the display area and does not display images. In the display panel, visibility at various angles may be improved or the planar area of the non-display area may be reduced by bending at least a portion of the peripheral area.

One or more embodiments include a display apparatus with a reduced planar area of a peripheral area viewed by a user, and a method of manufacturing (or providing) the display apparatus.

However, such a technical problem is an example, and the present invention is not limited thereto.

Additional aspects will be set forth in part in the description which follows and, in part, will be apparent from the description, or may be learned by practice of the presented embodiments of the present invention.

According to one or more embodiments, a display apparatus includes a display panel including a display area, a first adjacent portion, and a bent portion, where the first adjacent portion is arranged outside the display area and surrounds a portion of the display area, and the bent portion disposed under the first adjacent portion, and a cover window disposed to cover the display panel, where the first adjacent portion overlaps at least a portion of the bent portion in a plan view.

The bent portion may be bent under the first adjacent portion.

An entirety of the bent portion may be arranged inside a circumference or a planar area of the first adjacent portion in a plan view when the bent portion is bent (i.e., in a bent state).

The first adjacent portion may be separated or spaced apart from the bent portion in a thickness direction.

The display apparatus may further include a protector disposed to fill a separation space defined between the first adjacent portion and the bent portion.

The display panel may further include a separation layer arranged between the first adjacent portion and the bent portion.

The separation layer may be arranged under the first adjacent portion and may be separated from the bent portion.

The separation layer may be arranged to overlap the first adjacent portion in a plan view.

The display panel may further include a display element arranged in the display area and may include a pixel electrode and an opposite electrode, a thin-film transistor connected to the display element, an insulating layer covering the thin-film transistor, a pixel-defining layer disposed on the insulating layer, and an encapsulation layer disposed on the pixel-defining layer, where the first adjacent portion may include the pixel-defining layer disposed on the separation layer and the encapsulation layer disposed on the pixel-defining layer, and the bent portion may include an insulating layer disposed under the separation layer and separated from the separation layer.

The bent portion may be bent under the encapsulation layer to overlap the encapsulation layer in a plan view.

The bent portion may further include a connection line extending in an extension direction of the bent portion from the display area, and the connection line may be bent under the separation layer.

The display apparatus may further include a touch sensor layer disposed between the display panel and the cover window, where the first adjacent portion may further include a touch line disposed on the separation layer, and the touch line may be electrically connected to the touch sensor layer.

The touch line may be disposed under the pixel-defining layer to contact the separation layer.

The touch line may be disposed between the encapsulation layer and the pixel-defining layer and may include a same material as a material of the opposite electrode.

According to one or more embodiments, a method of manufacturing a display apparatus includes preparing a substrate including a display area, a first adjacent area, and a bent area, where the first adjacent area is arranged outside the display area and surrounds a portion of the display area, and the bent area overlaps at least a portion of the first adjacent area, disposing an insulating layer on the substrate, disposing a separation layer on the insulating layer in the first adjacent area, disposing an encapsulation layer to cover the separation layer, separating at least one of a first surface of the separation layer and a second surface facing the first surface, from a contacting layer, and bending the substrate in the bent area.

The display apparatus may include a first adjacent portion on the separation layer and a bent portion under the separation layer in the first adjacent area, and while the substrate is bent in the bent area, the bent portion may be bent under the first adjacent portion.

The first adjacent portion may include an encapsulation layer, and the bent portion may be bent under the encapsulation layer to overlap the encapsulation layer in a plan view.

The bent portion may be arranged inside a circumference of the separation layer in a plan view when the bent portion is bent (i.e., in a bent state).

The method may further include disposing a protector to fill a separation space separated between the first adjacent portion and the bent portion.

The separating of the at least one of the first surface of the separation layer and the second surface facing the first surface, from a contacting layer, may include irradiating an ultraviolet ray to the separation layer.

The separating of the at least one of the first surface of the separation layer and the second surface facing the first surface, from the contacting layer, may include applying heat to the separation layer.

These and/or other aspects will become apparent and more readily appreciated from the following description of the embodiments, the accompanying drawings, and claims.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of embodiments of the present invention will be more apparent from the following description taken in conjunction with the accompanying drawings, in which:
FIG. 1 is a schematic perspective view of a display apparatus according to an embodiment;
FIG. 2 is a schematic cross-sectional view of a display apparatus according to an embodiment;
FIG. 3 is a schematic equivalent circuit diagram of a pixel circuit applicable to a display panel;
FIGS. 4 and 5 are schematic plan views of a portion of a display panel according to an embodiment;
FIGS. 6A and 7A are schematic cross-sectional views of a display apparatus according to an embodiment, and FIGS. 6B and 7B are enlarged cross-sectional views of areas A6 and A7 in FIGS. 6A and 7A, respectively;
FIGS. 8A, 9A, 10A, 11A, 12A and 13A are schematic cross-sectional views of a display apparatus according to various embodiments, and FIGS. 8B, 9B, 10B, 11B, 12B and 13B are enlarged cross-sectional views of areas A8, A9, A10, A11, A12 and A13 of FIGS. 8A, 9A, 10A, 11A, 12A and 13A, respectively;
FIG. 14 is a schematic cross-sectional view of a method of manufacturing a display apparatus; and
FIGS. 15A, 16A and 17A are schematic cross-sectional views of the method of manufacturing a display apparatus, and FIGS. 15B, 16B and 17B are enlarged cross-sectional views of areas A15, A16 and A17 of FIGS. 15A, 16A and 17A, respectively, according to an embodiment.

### DETAILED DESCRIPTION

Reference will now be made in detail to embodiments, examples of which are illustrated in the accompanying drawings. In this regard, the present embodiments may have different forms and should not be construed as being limited to the descriptions set forth herein. Accordingly, the embodiments are merely described below, by referring to the figures, to explain aspects of the present description.

As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present invention allows for various changes and numerous embodiments, certain embodiments will be illustrated in the drawings and described in the written description. Effects and features of the present invention, and methods for achieving them will be clarified with reference to embodiments described below in detail with reference to the drawings. However, the present invention is not limited to the following embodiments and may be embodied in various forms.

Hereinafter, embodiments will be described with reference to the accompanying drawings, where like reference numerals refer to like elements throughout and a repeated description thereof is omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise. For example, "an element" has the same meaning as "at least one element," unless the context clearly indicates otherwise. "At least one" is not to be construed as limiting "a" or "an." "Or" means "and/or." As used herein, a reference number labeling a singular form of an element within the figures may be used to reference a plurality of the singular element within the text of the disclosure.

It will be understood that the terms "comprise," "comprising," "include" and/or "including" as used herein specify the presence of stated features or elements but do not preclude the addition of one or more other features or elements.

It will be further understood that, when a layer, region, or element is referred to as being related to another element such as being "on" another layer, region, or element, it can be directly or indirectly on the other layer, region, or element. That is, for example, intervening layers, regions, or elements may be present. In contrast, when a layer, region, or element is referred to as being related to another element such as being "directly on" another layer, region, or element, no intervening layer, region, or element is present.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and the present invention, and will not be interpreted in an idealized or overly formal sense unless expressly so defined herein.

Sizes of elements in the drawings may be exaggerated or reduced for convenience of explanation. As an example, the size and thickness of each element shown in the drawings are arbitrarily represented for convenience of description, and thus, the present invention is not necessarily limited thereto.

The X-axis, the Y-axis and the Z-axis are not limited to three axes of the rectangular coordinate system, and may be interpreted in a broader sense. For example, the X-axis, the Y-axis, and the Z-axis may be perpendicular to one another, or may represent different directions that are not perpendicular to one another.

In the case where a certain embodiment may be implemented differently, a specific process order may be performed in the order different from the described order. As an example, two processes successively described may be simultaneously performed substantially and performed in the opposite order.

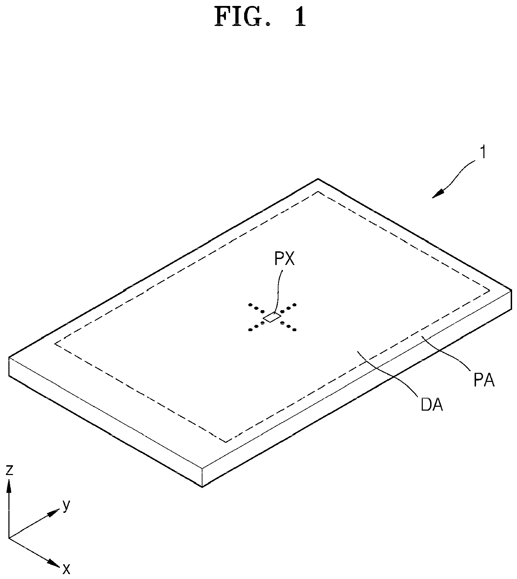

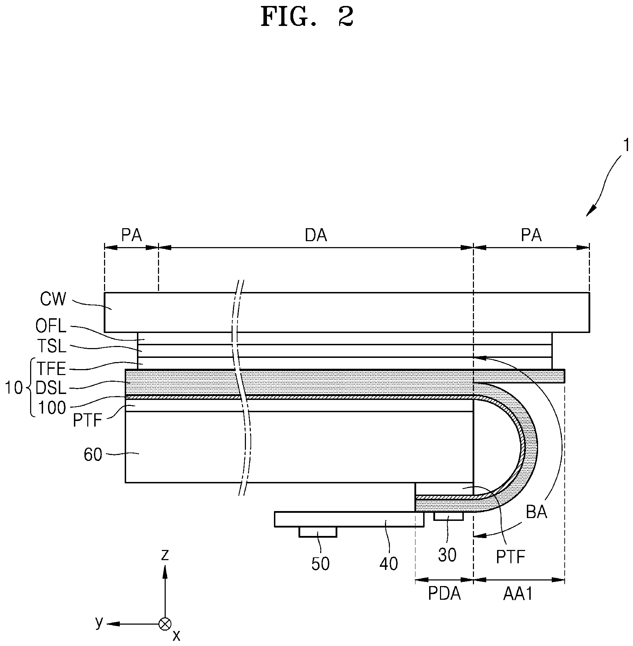

FIG. 1 is a schematic perspective view of a display apparatus 1 according to an embodiment. FIG. 2 is a schematic cross-sectional view of the display apparatus 1 according to an embodiment.

Referring to FIG. 1, the display apparatus 1 may be used as a display screen of various products including televisions, notebook computers, monitors, advertisement boards, Internet of things (loTs) apparatuses as well as portable electronic apparatuses including mobile phones, smart phones, tablet personal computers (PCs), mobile communication terminals, electronic organizers, electronic books, portable multimedia players (PMPs), navigations, and ultra mobile personal computers (UMPCs). In addition, the display apparatus 1 according to an embodiment may be used in wearable devices including smartwatches, watchphones, glasses-type displays, and head-mounted displays (HMDs). In addition, the display apparatus 1 according to an embodiment may be used as instrument panels for automobiles, center fascias for automobiles, or center information displays (CIDs) arranged on a dashboard, room mirror displays that replace side mirrors of automobiles, and displays arranged on the backside of front seats as an entertainment for back seats of automobiles.

The display apparatus 1 may have an approximately rectangular shape as shown in FIG. 1. As an example, the display apparatus 1 may have a rectangular planar shape as a whole, having short sides extending in a first direction (e.g., an x direction or a -x direction) and long sides extending in a second direction (e.g., a y direction or a -y direction) as shown in FIG. 1. In an embodiment, a portion or a corner where a short side extending in the first direction (e.g., the x direction or the -x direction) meets a long side extending in the second direction (e.g., the y direction or the -y direction) may have a rectangular shape or a round shape with a preset curvature. In addition, the planar shape of the display apparatus 1 is not limited to rectangular shapes but may have other polygons, circular shapes, or elliptical shapes.

Referring to FIG. 1, the display apparatus 1 which is foldable, rollable, bendable, etc. may be flat or unfolded to be disposed in a plane defined by the first direction and the second direction crossing each other. A thickness of the display apparatus 1 and various layers or components thereof may be defined along a third direction (e.g., the z direction or the -z direction), to define a thickness direction.

The display apparatus 1 may include a display area DA and a peripheral area PA. The display area DA may be configured to display images. In this case, a pixel PX provided in plural including pixels PX may be arranged in the display area DA. The display apparatus 1 may be configured to display images by using light emitted from the pixels PX. Each pixel PX may be configured to emit light by using a display element. In an embodiment, each pixel PX may be configured to emit red, green, or blue light. In an embodiment, each pixel PX may be configured to emit red, green, blue, or white light.

The peripheral area PA may be a non-display area in which images are not displayed. The peripheral area PA may be adjacent to the display area DA, such as to surround at least a portion of the display area DA. As an example, the peripheral area PA may surround the display area DA entirely. A driver, a power line, or the like may be arranged in the peripheral area PA, where the driver is configured to provide electrical signals to the pixels PX, and the power line is configured to provide power. As an example, a scan driver may be arranged in the peripheral area PA, where the scan driver is configured to apply scan signals to the pixels PX. In addition, a data driver may be arranged in the peripheral area PA, where the data driver is configured to apply data signals to the pixels PX.

Referring to FIG. 2, the display apparatus 1 may include a display panel 10, a touch sensor layer TSL, an optical functional layer OFL, a cover window CW, a display driver 30, a display circuit board 40, a touch sensor driver 50, a cushion layer 60, and a protective film PTF.

The display panel 10 may be configured to display information processed by the display apparatus 1. As an example, the display panel 10 may display execution screen information of an application driven in the display apparatus 1, or user interface (Ul) and graphic user interface (GUI) information corresponding to the execution screen information.

The display panel 10 may include the display element. As an example of a display element, the display panel 10 may include an organic light-emitting display panel that uses organic light-emitting diodes, a micro light-emitting diode display panel that uses micro light-emitting diodes (LED), a quantum-dot light-emitting display panel that uses a quantum-dot emission layer, or an inorganic light-emitting display panel that uses inorganic light-emitting elements including an inorganic semiconductor. Hereinafter, the case where the display panel 10 is an organic light-emitting display panel that uses organic light-emitting diodes as display elements is mainly described in detail.

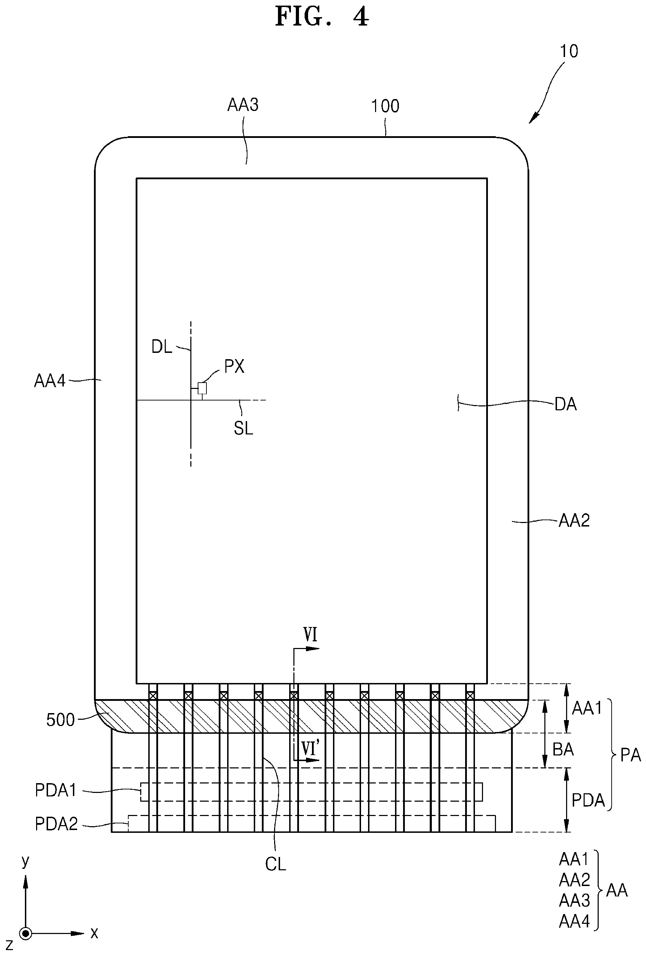

The display panel 10 may include a substrate 100 and a multi-layer (or stacked structure) which is disposed on the substrate 100. In an embodiment, the display panel 10 may include the substrate 100, a display layer DSL, and an encapsulation layer TFE. In this case, the display area DA and the peripheral area PA may be defined in the substrate 100 and/or the multi-layer. That is, various layers and components of the display apparatus 1 may include a display area DA and a peripheral area PA corresponding to those described above As an example, the display panel 10 may include the display area DA and the peripheral area PA. In addition, the peripheral area PA may include an adjacent area AA surrounding the display area DA, a pad area PDA, and a bending area (e.g., a bent area BA in FIG. 4). The bent area BA may be an area at which the display apparatus 1 and/or various components or layers thereof is foldable, rollable, bendable, etc.

The substrate 100 may include glass or polymer resin such as polyethersulfone, polyarylate, polyetherimide, polyethylene naphthalate, polyethylene terephthalate, polyphenylene sulfide, polyimide, polycarbonate, cellulose tri acetate, cellulose acetate propionate, and the like. In an embodiment, the substrate 100 may have a multi-layered structure including a base layer and a barrier layer (not shown) each including the above polymer resin. The substrate 100 including the polymer resin is flexible, rollable, or bendable.

The substrate 100 may be bendable at the bent area BA. Referring to FIG. 2, for example, the display apparatus 1 which is bent at the bent area BA includes portions of a lower surface of the substrate 100 facing each other, and the pad area PDA of the substrate 100 disposed lower than other portions of the substrate 100. Accordingly, the area (e.g., a planar area along the plane defined by the first and second directions crossing each other) of the peripheral area PA viewable along the thickness direction (e.g., viewed by a user) may be reduced. In an embodiment, at least a portion of the display layer DSL, at least a portion of the encapsulation layer TFE, and at least a portion of the touch sensor layer TSL may be also provided in the bent area BA and the pad area PDA. In this case, at least a portion of the display layer DSL, at least a portion of the encapsulation layer TFE, and at least a portion of the touch sensor layer TSL may be also bendable at the bent area BA.

The display layer DSL may be disposed on the substrate 100. The display layer DSL may include pixel circuits and display elements. In this case, the pixel circuits may be variously connected to the display elements. The pixel circuit PC may include a thin-film transistor and a storage capacitor Cst. Accordingly, the display layer DSL may include a plurality of display elements, a plurality of thin-film transistors, and a plurality of storage capacitors. In addition, the display layer DSL may further include insulating layers variously disposed therebetween the elements of the pixel circuits and display elements.

The encapsulation layer TFE may be disposed on the display layer DSL. The encapsulation layer TFE may be disposed on the display element and may cover the display element. In an embodiment, the encapsulation layer TFE may include at least one inorganic encapsulation layer and at least one organic encapsulation layer. The at least one inorganic encapsulation layer may include at least one inorganic material among aluminum oxide (Al₂O₃), titanium oxide (TiO₂), tantalum oxide (Ta₂O₅), zinc oxide (ZnOₓ), silicon oxide (SiO₂), silicon nitride (SiNₓ), and silicon oxynitride (SiOₓN_{y}). The at least one organic encapsulation layer may include a polymer-based material. The polymer-based material may include an acryl-based resin, an epoxy-based resin, polyimide, and polyethylene. In an embodiment, the at least one organic encapsulation layer may include acrylate.

The touch sensor layer TSL may be disposed on the encapsulation layer TFE. The touch sensor layer TSL may obtain coordinate information corresponding to an external input, for example, a touch event. The touch sensor layer TSL may include a sensor electrode and touch lines connected to the sensor electrode. The touch sensor layer TSL may sense an external input by using a self-capacitance method or a mutual capacitance method.

The touch sensor layer TSL may be disposed on the encapsulation layer TFE. Alternatively, the touch sensor layer TSL may be separately formed on a touch substrate and then coupled to the encapsulation layer TFE through an adhesive layer such as an optically clear adhesive. In an embodiment, the touch sensor layer TSL may be directly formed on the encapsulation layer TFE. In this case, the adhesive layer may not be disposed between the touch sensor layer TSL and the encapsulation layer TFE.

The optical functional layer OFL may be disposed on the touch sensor layer TSL. The optical functional layer OFL may reduce the reflectivity of light (external light) incident toward the display apparatus 1 from outside (e.g., outside of the display apparatus 1), and/or improve the color purity of light emitted from the display apparatus 1. In an embodiment, the optical functional layer OFL may include a retarder and/or a polarizer. The retarder may include a film-type retarder or a liquid crystal-type retarder. The retarder may include a λ/2 retarder and/or a λ/4 retarder. The polarizer may include a film-type polarizer or a liquid crystal-type polarizer. The film-type polarizer may include a stretchable synthetic resin film, and the liquid crystal-type polarizer may include liquid crystals arranged in a predetermined arrangement. Each of the retarder and the polarizer may further include a protective film.

In an embodiment, the optical functional layer OFL may include a black matrix and color filters. The color filters may be arranged by taking into account colors of light emitted respectively from the pixels PX of the display apparatus 1. The color filters may each include red, green, or blue pigment or dye. Alternatively, the color filters may each further include quantum dots in addition to the pigment or dye. Alternatively, some of the color filters may not include pigment or dye, and may include scattering particles such as titanium oxide.

In an embodiment, the optical functional layer OFL may include a destructive interference structure. The destructive interference structure may include a first reflection layer and a second reflection layer respectively disposed on different layers. First-reflected light and second-reflected light respectively reflected by the first reflection layer and the second reflection layer may destructively interfere and thus the reflectivity of external light may be reduced.

In the case where the touch sensor layer TSL and/or the optical functional layer OFL are disposed on the display panel 10, the cover window CW may be disposed on the touch sensor layer TSL and/or the optical functional layer OFL. The cover window CW may be configured to protect the display panel 10. In an embodiment, the cover window CW may be a flexible window. The cover window CW may be configured to protect the display panel 10 while easily bending according to external force without occurrence of cracks and the like. The cover window CW may include at least one of glass, sapphire, and plastic. The cover window CW may be, for example, ultra-thin glass or colorless polyimide. In an embodiment, the cover window CW may have a structure in which a flexible polymer layer is disposed on one surface of a glass substrate, or include only a polymer layer.

The display driver 30 may be arranged in the pad area PDA. The display driver 30 may receive control signals and power voltages, generate and output signals and voltages for driving the display panel 10. The display driver 30 may include an integrated circuit (IC).

The display circuit board 40 may be electrically connected to the display panel 10. As an example, the display circuit board 40 may be electrically connected to the display panel 10 at the pad area PDA of the substrate 100 by an anisotropic conductive film.

The display circuit board 40 may be a flexible printed circuit board (FPCB) that may be bent or a rigid printed circuit board (PCB) that is rigid and not easily bent. Alternatively, the display circuit board 40 may be a composite printed circuit board including both a rigid printed circuit board and a flexible printed circuit board depending on the case.

The touch sensor driver 50 may be disposed on the display circuit board 40. The touch sensor driver 50 may include an integrated circuit. The touch sensor driver 50 may be attached to the display circuit board 40. The touch sensor driver 50 may be electrically connected to sensor electrodes of the touch sensor layer TSL of the display panel 10 through the display circuit board 40.

In addition, a power supply unit (not shown) may be additionally disposed on the display circuit board 40. The power supply unit may be configured to supply a driving voltage for driving the pixels PX of the display panel 10 and the display driver 30.

The protective film PTF may be patterned and attached to the lower surface of the substrate 100. In this case, the protective film PTF may be attached to a portion of the substrate 100 except for the bent area BA of the substrate 100. In this case, a first portion of the protective film PTF may be attached to the lower surface of the substrate 100 to correspond to the display area DA. A second portion of the protective film PTF may be attached to the lower surface of the substrate 100 to correspond to the pad area PDA. That is, the protective film PTF may include the first and second portions spaced apart from each other at the bent area BA to be disconnected at the bent area BA.

In an embodiment, the cushion layer 60 may be disposed between the first and second portions of the protective films PTF, along a thickness direction of the display apparatus 1 which is bent at the bent area BA. The cushion layer 60 may be configured to absorb external impact and prevent the display panel 10 from being destroyed. The cushion layer 60 may include a polymer resin such as polyurethane, polycarbonate, polypropylene, polyethylene, and the like, or include an elastic material such as rubber, a urethane-based material, a sponge foam-molded with an acryl-based material, and the like.

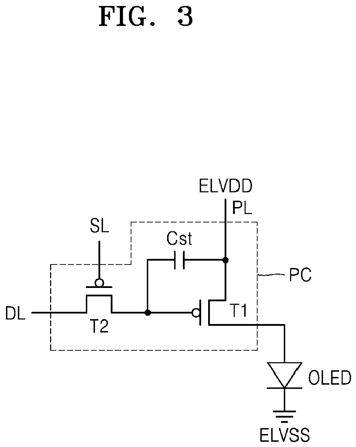

FIG. 3 is a schematic equivalent circuit diagram of a pixel circuit PC applicable to the display panel 10.

Referring to FIG. 3, the pixel circuit PC may be connected to a display element, for example, an organic light-emitting diode OLED. The pixel circuit PC may include a driving thin-film transistor T1, a switching thin-film transistor T2, and a storage capacitor Cst. In addition, the organic light-emitting diode OLED may be configured to emit red, green, or blue light, or emit red, green, blue, or white light.

The switching thin-film transistor T2 is connected to a scan line SL and a data line DL, and configured to transfer a data voltage or a data signal to the driving thin-film transistor T1 according to a switching voltage or a switching signal input from the scan line SL, the data voltage or the data signal being input from the data line DL. The storage capacitor Cst may be connected to the switching thin-film transistor T2 and a driving voltage line PL and configured to store a voltage corresponding to a difference between a voltage transferred from the switching thin-film transistor T2 and a first power voltage ELVDD supplied to the driving voltage line PL.

The driving thin-film transistor T1 may be connected to the driving voltage line PL and the storage capacitor Cst and configured to control a driving current according to the voltage stored in the storage capacitor Cst, the driving current flowing from the driving voltage line PL to the organic light-emitting diode OLED. The organic light-emitting diode OLED may be configured to emit light having a preset brightness corresponding to the driving current. An opposite electrode of the organic light-emitting diode OLED may be configured to receive a second power voltage ELVSS.

Though it is shown in FIG. 3 that the pixel circuit PC includes two thin-film transistors and one storage capacitor, the pixel circuit PC may include three, four, five, or more thin-film transistors.

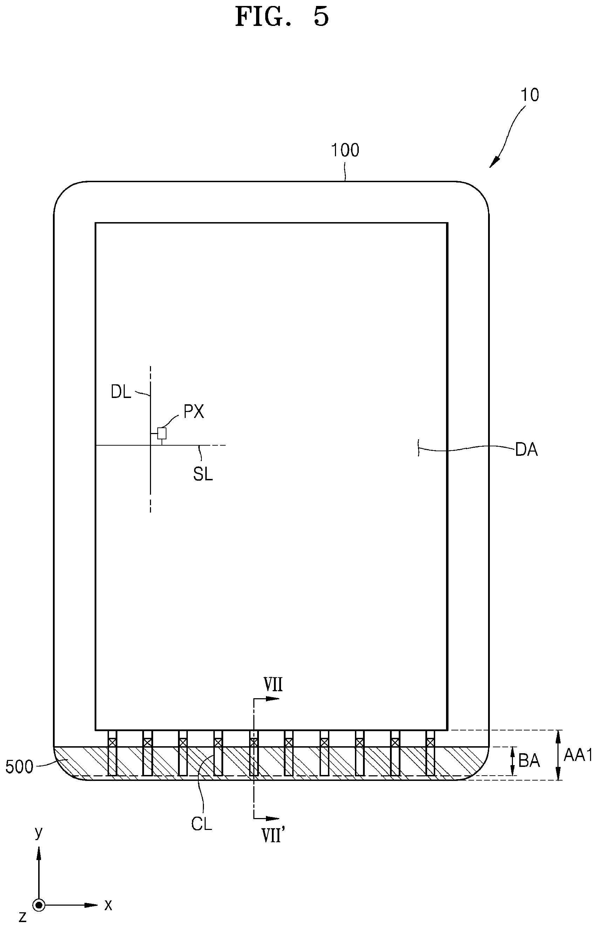

FIGS. 4 and 5 are schematic plan views of a portion of the display panel 10 according to an embodiment. FIG. 4 shows a shape before the bent area BA of the display panel 10 is bent and schematically shows a shape of the display panel 10 that is unfolded. FIG. 5 schematically shows a shape after the bent area BA of the display panel 10 is bent to define a shape of the display panel 10 that is bent.

Referring to FIGS. 4 and 5, the display panel 10 may include the display area DA and the peripheral area PA. In this case, pixels PX may be arranged in the display area DA. The pixels PX may be connected to the scan line SL and the data line DL, where the scan line SL extends in the first direction (e.g., the x direction of FIG. 4), and the data line DL extends in the second direction (e.g., the y direction of FIG. 4). The pixel PX may be configured to emit light using an organic light-emitting diode according to a scan signal and a data signal, where the scan signal is transferred through the scan line SL, and the data signal is transferred through the data line DL.

The peripheral area PA may be a non-display area in which images are not displayed. The peripheral area PA may surround at least a portion of the display area DA. The peripheral area PA may include the adjacent area AA together with the pad area PDA and the bent area BA. The adjacent area AA surrounds the display area DA, the pad area PDA is arranged on one side of the adjacent area AA, and the bent area BA is arranged between the pad area PDA and the adjacent area AA.

The adjacent area AA may surround the display area DA. As an example, in the case where the display area DA is formed in a quadrangular shape in a plan view, the adjacent area AA may include a first adjacent area AA1, a second adjacent area AA2, a third adjacent area AA3, and a fourth adjacent area AA4 respectively extending along a boundary of the display area DA and surrounding the sides of the display area DA. A boundary may be defined between the display area DA and the adjacent area AA. The portion of the display apparatus 1 from the display area DA and including the first adjacent area AA1 through a distal end of the pad area PDA may define an end portion of the display apparatus 1.

The pad area PDA may be arranged outside the display area DA, for example, closest to the first adjacent area AA1 and outside the first adjacent area AA1 in the plan view. In an embodiment, the pad area PDA may be arranged farther away from the display area DA than the bent area BA. The pad area PDA may include a first pad area PDA1 and a second pad area PDA2. In the pad area PDA, the first pad area PDA1 may be arranged closer to the display area DA than the second pad area PDA2. In an embodiment, the first pad area PDA1 may be a region in which the display driver 30 (see FIG. 2) is arranged. In the pad area PDA, the second pad area PDA2 may be arranged further away from the display area DA than the first pad area PDA1. The second pad area PDA2 may include or define the edge of the peripheral area PA. In an embodiment, the second pad area PDA2 may be a region in which the display circuit board 40 (see FIG. 2) is arranged.

The bent area BA may be arranged between the display area DA and the pad area PDA. In addition, the bent area BA may be arranged between the first adjacent area AA1 and the pad area PDA. The bent area BA is a region in which the display panel 10 is bent and may denote a bendable portion of the display panel 10. In an embodiment, at least a portion of the bent area BA may overlap the first adjacent area AA1 in a plan view. That is, a portion of layers constituting the display panel 10, for example, an upper layer forms the first adjacent area AA1, another portion of the layers constituting the display panel 10, for example, a lower layer forms the bent area BA, and bending may start below the first adjacent area AA1.

As in FIG. 5, the display panel 10 may be bent in the bent area BA. In an embodiment, the bent area BA may be bent below the first adjacent area AA1 to completely overlap the first adjacent area AA1 in a plan view. In other words, while the display panel 10 is bent, the bent area BA may be arranged inside the circumference of the first adjacent area AA1 in a plan view.

A connection line CL may be arranged in the bent area BA. The connection line CL may extend from the display area DA and in a direction from the display area DA to the pad area PDA. As an example, the connection line CL may extend in a second direction (e.g., a y direction of FIG. 4). The connection line CL may be provided in plurality. In this case, the connection lines CL may be arranged to be apart from each other. In an embodiment, the plurality of connection lines CL may be arranged in parallel to each other.

The connection line CL may be a signal line connected to various components or elements in the display area DA and configured to transfer signals to the display area DA. As an example, the connection line CL may be configured to transfer scan signals applied from the display driver 30 (see FIG. 2) or the display circuit board 40 (see FIG. 2) to the scan line SL of the pixel PX arranged in the display area DA. As another example, the connection line CL may be configured to transfer data signals applied from the display driver 30 (see FIG. 2) or the display circuit board 40 (see FIG. 2) to the data line DL of the pixel PX arranged in the display area DA. As another example, the connection line CL may be configured to transfer a power voltage to the display area DA. As another example, the connection line CL may be configured to receive touch signals transferred from a touch line TL arranged in the display area DA, to the touch sensor driver 50 (see FIG. 2) disposed on the display circuit board 40 (see FIG. 2).

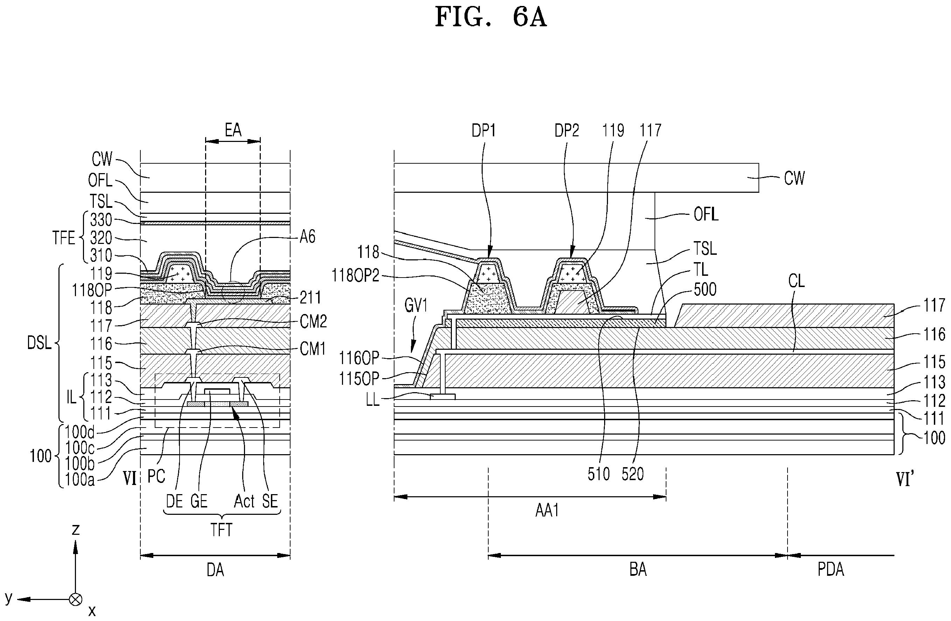

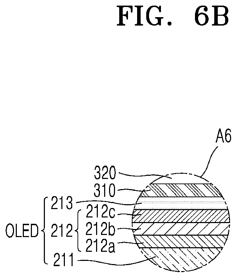

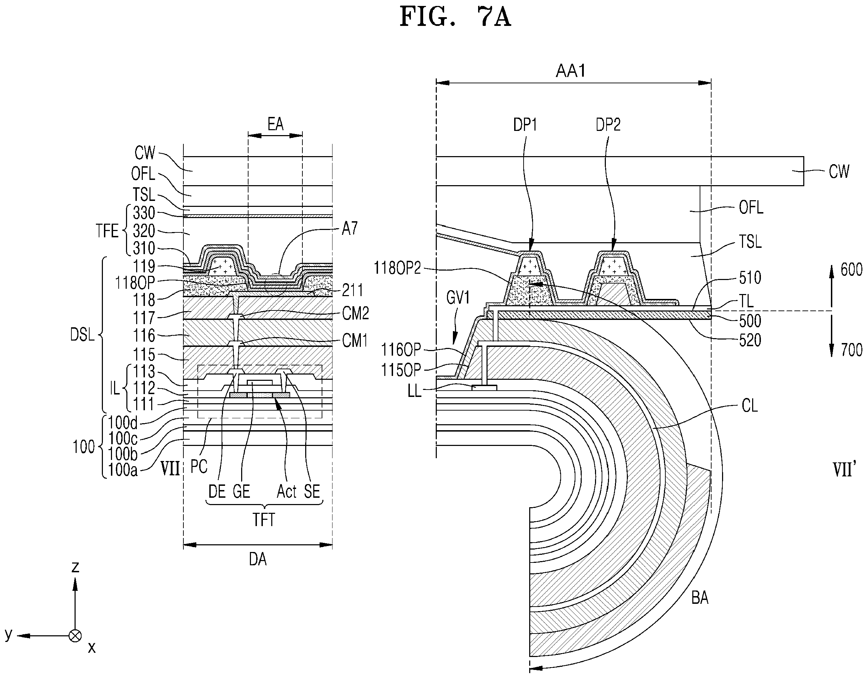

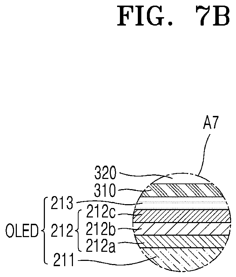

FIGS. 6A and 7A are schematic cross-sectional views of a display apparatus according to an embodiment, and FIGS. 6B and 7B are enlarged cross-sectional views of areas A6 and A7 in FIGS. 6A and 7A, respectively. Hereinafter, FIG. 6 may refer to FIGS. 6A and 6B together and FIG. 7 may refer to FIGS. 7A and 7B together. FIG. 6 may correspond to a cross-section of the display apparatus 1, taken along line VI-VI' of FIG. 4, and shows the touch sensor layer TSL, the optical functional layer OFL, and the cover window CW together disposed on the display panel 10. FIG. 7 may correspond to a cross-section of the display apparatus 1, taken along line VII-VII' of FIG. 5, and shows the touch sensor layer TSL, the optical functional layer OFL, and the cover window CW together disposed on the display panel 10.

Referring to FIGS. 6 and 7, the display apparatus 1 may include the display panel 10, the touch sensor layer TSL, the optical functional layer OFL, and the cover window CW. The display panel 10 may include the substrate 100, the display layer DSL, and the encapsulation layer TFE. As described above, the display panel 10 may include the display area DA and the peripheral area PA. The peripheral area PA may include the adjacent area AA, the pad area PDA, and the bent area BA. Accordingly, the substrate 100 may include the display area DA and the peripheral area PA.

In an embodiment, the substrate 100 may include a first base layer 100a, a first barrier layer 100b, a second base layer 100c, and a second barrier layer 100d. In an embodiment, the first base layer 100a, the first barrier layer 100b, the second base layer 100c, and the second barrier layer 100d may be sequentially stacked. Alternatively, the substrate 100 may include glass.

At least one of the first base layer 100a and the second base layer 100c may include polymer resin including polyethersulfone, polyarylate, polyetherimide, polyethylene naphthalate, polyethylene terephthalate, polyphenylene sulfide, polyimide, polycarbonate, cellulose tri acetate, and cellulose acetate propionate.

The first barrier layer 100b and the second barrier layer 100d are barrier layers configured to prevent penetration of external foreign materials and may include a single layer or a multi-layer including an inorganic material, such as silicon nitride (SiNₓ), silicon oxide (SiO₂), and/or silicon oxynitride (SiOₓN_{y}).

The display layer DSL may be disposed on the substrate 100 in the display area DA. The display layer DSL may include an inorganic insulating layer IL, the pixel circuit PC, a first insulating layer 115, a second insulating layer 116, a third insulating layer 117, and the organic light-emitting diode OLED. The inorganic insulating layer IL may include a buffer layer 111, a first gate insulating layer 112, and an interlayer insulating layer 113. The pixel circuit PC may include a thin-film transistor TFT.

The buffer layer 111 may be disposed on the substrate 100. The buffer layer 111 may include an inorganic insulating material such as silicon nitride (SiNₓ), silicon oxynitride (SiOₓN_{y}), and silicon oxide (SiO₂), and include a single layer or a multi-layer including the inorganic insulating materials.

The thin-film transistor TFT may include a semiconductor layer Act, and the semiconductor layer Act may be disposed on the buffer layer 111. The semiconductor layer Act may include polycrystalline silicon. Alternatively, the semiconductor layer Act may include amorphous silicon, an oxide semiconductor, or an organic semiconductor. The semiconductor layer Act may include a channel region, a drain region, and a source region, the drain region and the source region being on two opposite sides of the channel region. A gate electrode GE may overlap the channel region.

The gate electrode GE may include a low-resistance metal material. The gate electrode GE may include a conductive material including molybdenum (Mo), aluminum (Al), copper (Cu), and titanium (Ti) and have a single-layered structure or a multi-layered structure including the above materials.

The first gate insulating layer 112 between the semiconductor layer Act and the gate electrode GE may include an inorganic insulating material including silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO).

The interlayer insulating layer 113 may cover the gate electrode GE. Similar to the first gate insulating layer 112, the interlayer insulating layer 113 may include an inorganic insulating material including silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO).

Though not shown in the drawing, in an embodiment, the storage capacitor Cst may overlap the thin-film transistor TFT. For this purpose, an upper electrode may be disposed over the gate electrode GE to overlap the gate electrode GE. In this case, the upper electrode may include aluminum (Al), platinum (Pt), palladium (Pd), silver (Ag), magnesium (Mg), gold (Au), nickel (Ni), neodymium (Nd), iridium (Ir), chrome (Cr), calcium (Ca), molybdenum (Mo), titanium (Ti), tungsten (W), and/or copper (Cu), and include a single layer or a multi-layer including the above materials.

A drain electrode DE and a source electrode SE may each be disposed on the interlayer insulating layer 113. The drain electrode DE and the source electrode SE may each include a material having high conductivity. The drain electrode DE and the source electrode SE may each include a conductive material including molybdenum (Mo), aluminum (Al), copper (Cu), and titanium (Ti) and include a single layer or a multi-layer including the above materials. In an embodiment, the drain electrode DE and the source electrode SE may each have a multi-layered structure of Ti/AI/Ti.

The first insulating layer 115 may cover the drain electrode DE and the source electrode SE. The first insulating layer 115 may include an organic insulating layer. The first insulating layer 115 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

A first connection electrode CM1 may be disposed on the first insulating layer 115. In this case, the first connection electrode CM1 may be connected to the drain electrode DE or the source electrode SE through (or at) a contact hole of the first insulating layer 115. The first connection electrode CM1 may include a material having a high conductivity. The first connection electrode CM1 may include a conductive material including molybdenum (Mo), aluminum (Al), copper (Cu), and titanium (Ti) and have a single-layered structure or a multi-layered structure including the above materials. In an embodiment, the first connection electrode CM1 may have a multi-layered structure of Ti/AI/Ti.

The second insulating layer 116 may cover the first connection electrode CM1. The second insulating layer 116 may include an organic insulating layer. The second insulating layer 116 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

A second connection electrode CM2 may be disposed on the second insulating layer 116. In this case, the second connection electrode CM2 may be connected to the first connection electrode CM1 through a contact hole of the second insulating layer 116. The second connection electrode CM2 may include a material having a high conductivity. The second connection electrode CM2 may include a conductive material including molybdenum (Mo), aluminum (Al), copper (Cu), and titanium (Ti) and have a single-layered structure or a multi-layered structure including the above materials. In an embodiment, the second connection electrode CM2 may have a multi-layered structure of Ti/AI/Ti.

The third insulating layer 117 may cover the second connection electrode CM2. The third insulating layer 117 may include an organic insulating layer. The third insulating layer 117 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

The organic light-emitting diode OLED may be disposed on the third insulating layer 117. The organic light-emitting diode OLED may be configured to emit red, green, or blue light, or emit red, green, blue, or white light. The organic light-emitting diode OLED may include a pixel electrode 211, an intermediate layer 212, and an opposite electrode 213.

The pixel electrode 211 may be disposed on the third insulating layer 117. The pixel electrode 211 may be electrically connected to the second connection electrode CM2 through a contact hole of the third insulating layer 117. The pixel electrode 211 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In another embodiment, the pixel electrode 211 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. In another embodiment, the pixel electrode 211 may further include a layer on/under the reflective layer, the layer including ITO, IZO, ZnO, or In₂O₃. As an example, the pixel electrode 211 may have a multi-layered structure of ITO/Ag/ITO.

A pixel-defining layer 118 may be disposed on the pixel electrode 211, where the pixel-defining layer 118 includes (or defines) an opening 118OP exposing a central portion of the pixel electrode 211. The pixel-defining layer 118 may include an organic insulating material and/or an inorganic insulating material. The opening 118OP may define an emission area EA of the display panel 10 at which light emitted from the organic light-emitting diode OLED is emitted from the display panel 10 (or at the display area DA).

Various patterns within the display panel 10 may have a dimension (e.g., a planar dimension) defined along a plane. The dimension like a width, may be defined in a direction along the substrate 100. As an example, the width of the opening 118OP which extends in a direction along the substrate 100 (e.g., along the y direction in FIG. 6A) may correspond to the width of the emission area EA along the same direction.

A spacer 119 may be disposed on the pixel-defining layer 118. The spacer 119 may include an organic insulating material such as polyimide. Alternatively, the spacer 119 may include an inorganic insulating material such as silicon nitride (SiNₓ) or silicon oxide (SiO₂), or include an organic insulating material and an inorganic insulating material.

In an embodiment, the spacer 119 may include a different material from a material of the pixel-defining layer 118. Alternatively, in another embodiment, the spacer 119 may include the same material as a material of the pixel-defining layer 118. In this case, the pixel-defining layer 118 and the spacer 119 may be formed together during a mask process that uses a half-tone mask and the like.

The intermediate layer 212 may be disposed on the pixel-defining layer 118. The intermediate layer 212 may include an emission layer 212b disposed in the opening 118OP of the pixel-defining layer 118. The emission layer 212b may include a polymer organic material or a low-molecular weight organic material emitting light having a preset color.

A first functional layer 212a and a second functional layer 212c may be respectively arranged under and above the emission layer 212b. The first functional layer 212a may include, for example, a hole transport layer (HTL), or include an HTL and a hole injection layer (HIL). The second functional layer 212c is disposed on the emission layer 212b and is optional. The second functional layer 212c may include an electron transport layer (ETL) and/or an electron injection layer (EIL). Like the opposite electrode 213 described below, the first functional layer 212a and/or the second functional layer 212c may be common layers covering the substrate 100 entirely.

The opposite electrode 213 may include a conductive material having a low work function. As an example, the opposite electrode 213 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the opposite electrode 213 may further include a layer on the (semi) transparent layer, the layer including ITO, IZO, ZnO, or In₂O₃.

In an embodiment, a capping layer (not shown) may be further arranged on the opposite electrode 213. The capping layer may include lithium fluoride (LiF), an inorganic material, and/or an organic material.

The encapsulation layer TFE may cover the organic light-emitting diode OLED. That is, the encapsulation layer TFE may be disposed on the opposite electrode 213. In an embodiment, the encapsulation layer TFE may include at least one inorganic encapsulation layer and at least one organic encapsulation layer. In an embodiment, it is shown in FIG. 6 that the thin-film encapsulation layer TFE includes a first inorganic encapsulation layer 310, an organic encapsulation layer 320, and a second inorganic encapsulation layer 330 that are sequentially stacked.

The first inorganic encapsulation layer 310 and the second inorganic encapsulation layer 330 may each include at least one inorganic material among aluminum oxide (Al₂O₃), titanium oxide (TiO₂), tantalum oxide (Ta₂O₅), hafnium oxide (HfO₂), zinc oxide (ZnO₂), silicon oxide (SiO₂), and silicon nitride (SiNₓ), silicon oxynitride (SiOₓN_{y}). The organic encapsulation layer 320 may include a polymer-based material. The polymer-based material may include an acryl-based resin, an epoxy-based resin, polyimide, and polyethylene. In an embodiment, the organic encapsulation layer 320 may include acrylate.

The touch sensor layer TSL may be disposed on the thin-film encapsulation layer TFE. The touch sensor layer TSL may include insulating layers and conductive layers that are alternately stacked. As an example, the touch sensor layer TSL may include a first conductive layer and a second conductive layer facing each other. In this case, a first touch insulating layer may be disposed between the first conductive layer and the second conductive layer. A second touch insulating layer may be disposed on the second conductive layer. In an embodiment, an inorganic insulating layer may be further included between the second inorganic encapsulation layer 330 and the first conductive layer.

A sensor electrode of the touch sensor layer TSL and touch lines connected to the sensor electrode may be included in at least one of the first conductive layer and the second conductive layer. The first conductive layer or the second conductive layer may include a metal layer or a transparent conductive layer. The metal layer may include at least one of molybdenum (Mo), mendelevium (Md), silver (Ag), titanium (Ti), copper (Cu), aluminum (Al), and an alloy thereof. The transparent conductive layer may include a transparent conductive oxide such as indium tin oxide (ITO), indium zinc oxide (IZO), zinc oxide (ZnO), and indium tin zinc oxide (ITZO). In addition, the transparent conductive layer may include a conductive polymer such as poly-3,4-ethylene dioxy thiophene (PEDOT), metal nanowires, graphene, and the like.

The first conductive layer or the second conductive layer may include a single layer or a multi-layer. The first conductive layer or the second conductive layer of a single layer may include a metal layer or a transparent conductive layer, and materials of the metal layer and the transparent conductive layer are the same as those described above. One of the first conductive layer and the second conductive layer may include a single metal layer. One of the first conductive layer and the second conductive layer may include a metal layer of a multi-layer. The metal layer of a multi-layer may include, for example, three layers of a titanium layer/an aluminum layer/a titanium layer, or include two layers of a molybdenum layer/a mendelevium layer. Alternatively, the metal layer of a multi-layer may include a metal layer and a transparent conductive layer. The first conductive layer and the second conductive layer may have different stack structures or have the same stack structure. As an example, the first conductive layer may include a metal layer, and the second conductive layer may include a transparent conductive layer. Alternatively, the first conductive layer and the second conductive layer may include the same metal layer.

The first touch insulating layer and the second touch insulating layer may each include an inorganic insulating material and/or an organic insulating material. The inorganic insulating material may include silicon oxide (SiO₂), silicon nitride (SiNₓ), or silicon oxynitride (SiOₓN_{y}), and the organic insulating material may include a polymer organic material.

The inorganic insulating layer IL may include a portion in the display area DA and a portion arranged in the peripheral area PA. That is, the inorganic insulating layer IL may extend from the display area DA to the peripheral area PA. In an embodiment, referring to FIG. 6A for example, the inorganic insulating layer IL may be arranged in the adjacent area AA, for example, the first adjacent area AA1, the bent area BA, and the pad area PDA.

A portion of the first insulating layer 115 may be disposed on the inorganic insulating layer IL, in the peripheral area PA. The first insulating layer 115 may include a first opening 115OP exposing the upper surface of the inorganic insulating layer IL, specifically, the interlayer insulating layer 113 thereof, to outside the first insulating layer 115. Since the first insulating layer 115 is separated or disconnected at the first opening 115OP, a penetration path of oxygen and/or moisture through the first insulating layer 115 and between the display area DA and the peripheral area PA may be blocked.

The second insulating layer 116 may be disposed on the first insulating layer 115. The second insulating layer 116 may include a second opening 116OP exposing the upper surface of the inorganic insulating layer IL, specifically, the interlayer insulating layer 113 thereof, to outside the second insulating layer 116. In an embodiment, the second opening 116OP may be arranged to overlap the first opening 115OP, such as to be aligned therewith. The first opening 115OP and the second opening 116OP may be continuous to form one opening exposing the upper surface of the inorganic insulating layer IL, specifically, the interlayer insulating layer 113 thereof to outside the various insulating layers. In other words, the first opening 115OP and the second opening 116OP may together configure a first groove GV1.

In an embodiment, the connection line CL may be disposed between the first insulating layer 115 and the second insulating layer 116. The connection line CL may be disposed on the first insulating layer 115 and covered by the second insulating layer 116. The connection line CL may extend from the first adjacent area AA1 to the pad area PDA, through the bent area BA. The connection line CL may be configured to transfer at least one of a scan signal, a data signal, and a power voltage.

In an embodiment, the connection line CL may be disposed on the same layer as a layer on which the first connection electrode CM1 is disposed and may include the same material as a material of the first connection electrode CM1. In other words, the connection line CL may be formed by the same process as a process of forming the first connection electrode CM1. As being on a same layer or in a same layer, elements may be formed in a same process and/or as including a same material as each other, elements may be respective portions or patterns of a same material layer, elements may be on or in a same layer by forming an interface with a same underlying or overlying layer, etc., without being limited thereto.

The connection line CL may be connected to a lower line LL through a contact hole arranged in the first adjacent area AA1, for example, a contact hole passing through the first insulating layer 115 and the interlayer insulating layer 113. In an embodiment, the lower line LL may be disposed on the first gate insulating layer 112. The lower line LL may be disposed on the same layer as a layer on which the gate electrode GE is disposed and may include the same material as a material of the gate electrode GE. In other words, the lower line LL may be formed by the same process as a process of forming the gate electrode GE. The lower line LL may extend from the peripheral area PA to the display area DA and be configured to transfer at least one of a scan signal, a data signal, and a power voltage between the peripheral area PA and the display area DA.

The pixel-defining layer 118 may be disposed on the second insulating layer 116. The pixel-defining layer 118 may include a third opening 118OP2 forming the first groove GV1. In an embodiment, the third opening 118OP2 may overlap the first opening 115OP and the second opening 116OP in a plan view and form a single opening together with the first opening 115OP and the second opening 116OP.

A first dam portion DP1 may be arranged adjacent to the first groove GV1 in the first adjacent area AA1 to surround the display area DA in a plan view. In an embodiment, the first dam portion DP1 may include respective patterns of the pixel-defining layer 118 and the spacer 119 which are in the peripheral area PA. In other words, the first dam portion DP1 may be defined by respective portions of the pixel-defining layer 118 and the spacer 119.

In addition, a second dam portion DP2 may be arranged in the first adjacent area AA1 to surround the display area DA. The second dam portion DP2 may be arranged to surround the first dam portion DP1 in the plan view. In an embodiment, the second dam portion DP2 may include respective patterns of the third insulating layer 117, the pixel-defining layer 118, and the spacer 119. That is, the third insulating layer 117, the pixel-defining layer 118, and a spacer layer may be in both the display area DA and the peripheral area PA and respectively include patterns in a same layer as each other.

In another embodiment, the second dam portion DP2 may include respective patterns of the pixel-defining layer 118 and the spacer 119. In addition, though it is shown in FIG. 6 that the second dam portion DP2 is arranged further from the display area DA than the first dam portion DP1 such as to surround the first dam portion DP1, it may be understood that the second dam portion DP2 may not be arranged selectively. Hereinafter, the case where the second dam portion DP2 is arranged is mainly described.

The encapsulation layer TFE may extend from the display area DA and into the peripheral area PA to be disposed to cover the first groove GV1, the first dam portion DP1, and the second dam portion DP2. The encapsulation layer TFE may include at least one inorganic encapsulation layer and at least one organic encapsulation layer. In an embodiment, the encapsulation layer TFE may include the first inorganic encapsulation layer 310, the organic encapsulation layer 320, and the second inorganic encapsulation layer 330 that are sequentially stacked.

At least one inorganic encapsulation layer, for example, the first inorganic encapsulation layer 310 of the encapsulation layer 300 may directly contact the interlayer insulating layer 113 in the first groove GV1. Specifically, the first inorganic encapsulation layer 310 may be arranged to be continuous from the display area DA to cover the entire surface of the first adjacent area AA1, for example, the first groove GV1, the first dam portion DP1, and the second dam portion DP2. Accordingly, an inorganic contact region in which an inorganic layer and an inorganic layer (e.g., two different inorganic layers) contact each other in the first groove GV1, specifically, on the interlayer insulating layer 113 to form sealing may be formed.

The organic encapsulation layer 320 may be disposed on the first inorganic encapsulation layer 310. The organic encapsulation layer 320 may be disposed to cover the display area DA and fill the first groove GV1 of the first adjacent area AA1. In an embodiment, the organic encapsulation layer 320 may be continuously arranged from the display area DA to the first dam portion DP1. The organic encapsulation layer 320 may be disposed by the first dam portion DP1 not to exceed the upper portion of the spacer pattern defined as a portion of the spacer layer of the first dam portion DP1. That is, a portion of the organic encapsulation layer 320 which is closest to the first dam portion DP1 is at a substantially same distance from the substrate 100 as the spacer pattern of the first dam portion DP1.

The second inorganic encapsulation layer 330 may be disposed on the organic encapsulation layer 320. Like the first inorganic encapsulation layer 310, the second inorganic encapsulation layer 330 may be arranged to be continuous from the display area DA to cover the entire surface of the first adjacent area AA1, for example, the first groove GV1, the first dam portion DP1, and the second dam portion DP2.

The touch sensor layer TSL may be disposed on the encapsulation layer TFE. The touch sensor layer TSL may be arranged in the first adjacent area AA1. In addition, the optical functional layer OFL may be disposed on the touch sensor layer TSL, and the cover window CW may be disposed to cover the optical functional layer OFL. In this case, an adhesive member (not shown) may be disposed between the optical functional layer OFL and the cover window CW. Accordingly, the cover window CW may be attached to the optical functional layer OFL by such adhesive member.

A separation layer 500 may be disposed between the second insulating layer 116 and the pixel-defining layer 118, in the first adjacent area AA1. In an embodiment, as shown in FIG. 4, the separation layer 500 may overlap the first adjacent area AA1 in a plan view. In addition, the separation layer 500 may define a portion of the boundary or edge of the first adjacent area AA1. In the first adjacent area AA1, the separation layer 500 overlap the first dam portion DP1 and the second dam portion DP2. In addition, a portion of the separation layer 500 which is adjacent to (e.g., closest to) the end of the first adjacent area AA1 which is furthest from the display area DA may not be covered by the encapsulation layer TFE.

In an embodiment, the separation layer 500 may include an organic layer including a polymer-based material and/or an inorganic layer. The polymer-based material may include acryl-based resin, urethane-based resin, and the like. In another embodiment, the separation layer 500 may include polyimide, epoxy-based resin, silicon oxide (SiOₓ), silicon nitride (SiNₓ), and the like.

A touch line TL of the touch sensor layer TSL may be disposed on the separation layer 500. The touch line TL may continuously extend under the first dam portion DP1 and the second dam portion DP2 to extend to the end of the separation layer 500. An end of the touch line TL may be aligned with the end of the separation layer 500 without being limited thereto. In addition, a portion of the touch line TL which is adjacent to the end of the first adjacent area AA1 may not be covered by the encapsulation layer TFE. As being not covered or not overlapping, an elements may be adjacent to and/or spaced apart from each other in a planar direction, such as in a direction along a respective insulating layer. Accordingly, the touch line TL may be electrically connected to the touch sensor layer TSL through a portion of the touch line TL which is not covered by (e.g., exposed by) the encapsulation layer TFE. In addition, the touch line TL may be electrically connected to the connection line CL through a contact hole passing through the separation layer 500 and the second insulating layer 116.

In an embodiment, the touch line TL may be disposed on the same layer as a layer on which the second connection electrode CM2 and may include the same material as a material of the second connection electrode CM2. In other words, the touch line TL may be formed by the same process as a process of forming the second connection electrode CM2.

In an embodiment, the separation layer 500 may include a first surface 510 and a second surface 520. The first surface 510 may be a surface (e.g., a surface in a +z direction of FIG. 6) of the separation layer 500 which faces the cover window CW or is closest to the cover window CW. The second surface 520 may be a surface (e.g., a surface in a -z direction of FIG. 6) of the separation layer 500 which faces the substrate 100 such as to be closer to the substrate 100 than the first surface 510. The first surface 510 and the second surface 520 may be surfaces facing in opposite directions from each other. As an example, the first surface 510 may contact the touch line TL and/or the pixel-defining layer 118, and the second surface 520 may contact the second insulating layer 116. As being in contact, elements may form an interface therebetween.

In an embodiment, the first surface 510 and/or the second surface 520 may be separated from a contacting layer (e.g., a layer which contacts the respective surface). Hereinafter, for convenience of description, the case where the second surface 520 is separated from a contacting layer, for example, the second insulating layer 116 is mainly described.

Referring to FIG. 7A, the display apparatus 1 (or the display panel 10) which is bent at the bent area BA includes the second surface 520 separated from the second insulating layer 116. This may be implemented by, for example, irradiating an ultraviolet ray or applying heat. In this case, the first surface 510 may remain in contact with and connected to the touch line TL and/or the pixel-defining layer 118, even in the display apparatus 1 (or the display panel 10) which is bent at the bent area BA. Accordingly, the display panel 10 may be separated into an upper layer and a lower layer with respect to the separation layer 500, in the first adjacent area AA1.

The first adjacent area AA1 of the display apparatus 1 (or the display panel 10) which is bent at the bent area BA may include the upper layer including, for example, a pattern portion of the pixel-defining layer 118, a pattern portion of the spacer layer, and portions of the encapsulation layer TFE on the separation layer 500. The upper layer, for example, the pixel-defining layer 118, the spacer 119, and the encapsulation layer TFE on the separation layer 500 may be defined as a first adjacent portion 600 (e.g., an adjacent portion). The various patterns and portions of layers in the first adjacent portion 600 may remain unbent or flat, such as being coplanar with the display area DA. The first adjacent area AA1 of the display apparatus 1 (or the display panel 10) which is bent at the bent area BA may include the lower layer including, for example, the second insulating layer 116, the first insulating layer 115, the inorganic insulating layer IL, and the substrate 100 which are under the separation layer 500. The lower layer, for example, the second insulating layer 116, the first insulating layer 115, the inorganic insulating layer IL, and the substrate 100 under the separation layer 500 may be a bendable portion at which the peripheral area PA is bendable to define a bent portion 700).

Since the second surface 520 of the separation layer 500 is separable from the second insulating layer 116, the bent portion 700 may be bent to be disposed under the separation layer 500 and spaced apart from the separation layer 500 as shown in FIG. 7A. That is, the bent portion 700 may be configured to start to bend at a position under the first adjacent portion 600. IN an embodiment, the bending of the substrate 100 may define a curvature of the bent portion 700 and such curvature may start at a location below the first adjacent area AA1 such as at a position corresponding to the separation layer 500. In this case, the first adjacent portion 600 may not be bent such as to be unbent. Since the first adjacent portion 600 is connected to the optical functional layer OFL attached to the cover window CW, and the touch sensor layer TSL attached to the optical functional layer OFL, the first adjacent portion 600 may be supported by attachment to the cover window CW via various layers, without being bent (e.g., while being flat or unbent).

In addition, as shown in FIG. 5, the bent portion 700 may be disposed under the first adjacent portion 600 along a thickness direction to overlap the first adjacent portion 600 in a plan view while the bent portion 700 is bent. In a plan view, the bent portion 700 may be arranged inside the a planar area of the first adjacent portion 600 which is defined in the display apparatus 1 (or the display panel 10) which is bent at the bent area BA. In other words, the bent portion 700 may overlap the various pattern portions of the pixel-defining layer 118, the spacer 119, and the encapsulation layer TFE which are in the adjacent area AA, particularly, the first inorganic encapsulation layer 310 and the second inorganic encapsulation layer 330 constituting the first adjacent portion 600. The bent portion 700 may overlap the first dam portion DP1 and the second dam portion DP2. In addition, the connection line CL forming or within the bent portion 700 may be also bent under the first adjacent portion 600 to overlap the first adjacent portion 600 along the thickness direction. As an example, the connection line CL may overlap the encapsulation layer TFE and be bent under the encapsulation layer TFE.

An end surface of the portion of the third insulating layer 117 which is in the display area DA may be spaced apart in a direction along the substrate 100 from the first adjacent area AA1 to the pad area PDA and disposed on the second insulating layer 116. The portion of the third insulating layer 117 in the adjacent area AA may continuously extend in the bent area BA and the pad area PDA. However, the embodiment is not limited thereto. In another embodiment, the third insulating layer 117 may be selectively omitted from among the bent area BA and the pad area PDA.

In the display apparatus 1 according to an embodiment, since a position at which bending of the bent portion 700 starts corresponds to a location under the first adjacent portion 600, the planar area of the non-display area due to the bending may be reduced. Specifically, in the conventional display device where the bent portion 700 is fixedly arranged with the first adjacent portion 600 and bending starts at a position outside of the second dam portion DP2, the area of the non-display area may be increased by as much as a bending curvature. In contrast, in the display apparatus 1 according to an embodiment, since bending starts inside the second dam portion DP2 and instead starts under the first adjacent portion 600 at the first dam portion DP1, the planar area of the non-display area (e.g., along the plane defined by the x direction and the y direction in FIGS. 6 and 7, for example) due to the bending may be reduced.

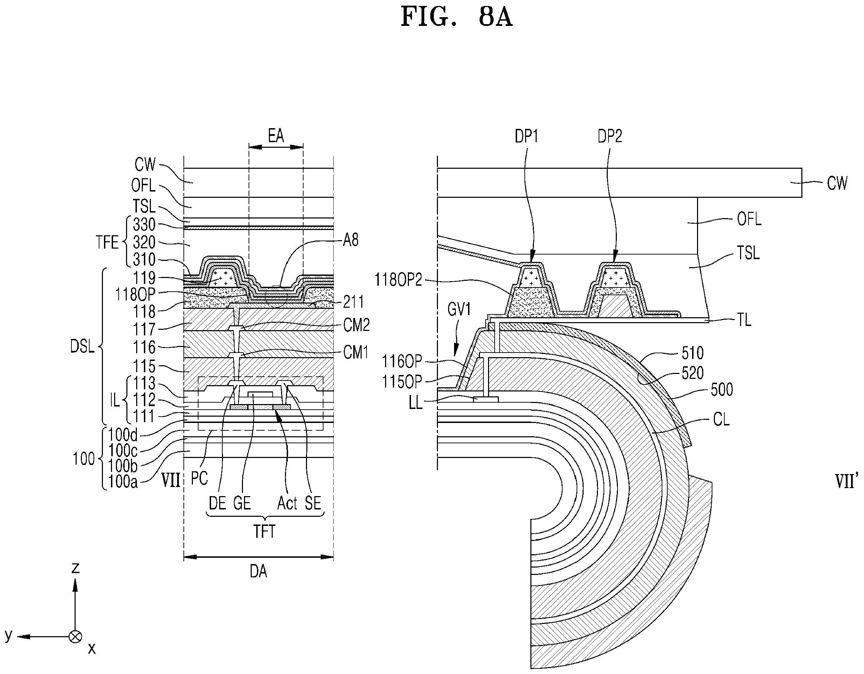

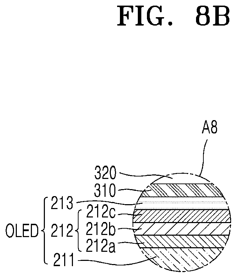

FIGS. 8A, 9A, 10A, 11A, 12A and 13A are schematic cross-sectional views of a display apparatus 1 according to various embodiments, and FIGS. 8B, 9B, 10B, 11B, 12B and 13B are enlarged cross-sectional views of areas A8, A9, A10, A11, A12 and A13 of FIGS. 8A, 9A, 10A, 11A, 12A and 13A, respectively. Hereinafter, FIG. 8, FIG. 9, FIG. 10, FIG. 11, FIG. 12 and FIG. 13 may refer to FIGS. 8A and 8B, FIGS. 9A and 9B, FIG. 10A and 10B, FIGS. 11A and 11B, FIGS. 12A and 12B, and FIGS. 13A and 13B, respectively together. Similar to FIG. 7, FIGS. 8 to 13 show the end portion of the display apparatus 1 (or the display panel 10) which is bent at the bent area BA.

Since the display apparatus 1 described with reference to FIGS. 8 to 13 is similar to the display apparatus 1 described above, only differences are mainly described below.

Referring to FIG. 8, in an embodiment, the first surface 510 of the separation layer 500 may be separable from a contacting layer, and the second surface 520 may not be separated from a contacting layer (e.g., contacting or fixed). Specifically, the first surface 510 of the separation layer 500 may be separated from the touch line TL and/or the pixel-defining layer 118. This may be implemented by, for example, irradiating an ultraviolet ray or applying heat. The second surface 520 of the separation layer 500 may remain in contact with and connected to a contacting layer, for example, the second insulating layer 116 without being separated from the second insulating layer 116. Accordingly, since the bent portion 700 is bent, the separation layer 500 may be bent under the first adjacent portion 600 together with the bent portion 700. In this case, since the first adjacent portion 600 is connected to the cover window CW and the optical functional layer OFL as described above, the first adjacent portion 600 which is unbent or flat may be supported by the cover window CW, the optical functional layer OFL, and the touch sensor layer TSL and may not be bent.

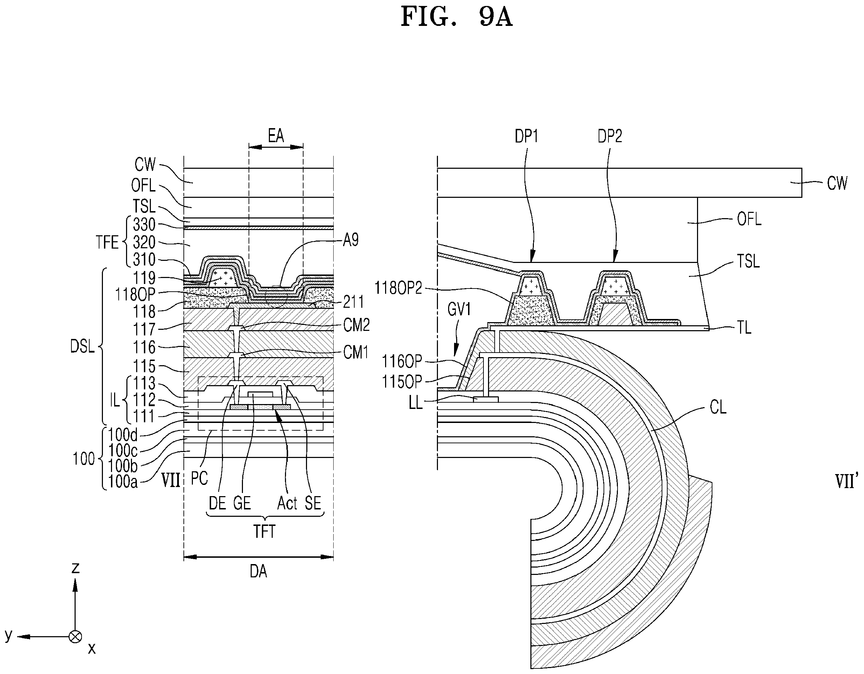

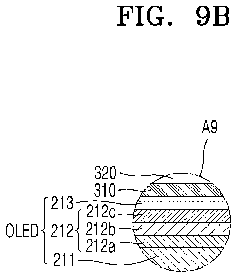

Referring to FIG. 9, in an embodiment, the separation layer 500 which is initially present may be removed and may not be present (e.g., be omitted). Specifically, the separation layer 500 may be ablated by irradiating an ultraviolet ray or applying heat to the separation layer 500. That is, when an ultraviolet ray is irradiated or heat is applied to the separation layer 500, the temperature of the surface of the separation layer 500 rises and the surface is melted and evaporated and thus removed. In this case, the separation layer 500 may include polyimide, epoxy-based resin, silicon oxide (SiOₓ), silicon nitride (SiNₓ), and the like. The removed separation layer may define a space or gap between the touch line TL and the portion of the second insulating layer 116 at the adjacent area AA.

Accordingly, the display panel 10 may be separated into the upper layer and the lower layer at a location from which the separation layer 500 is removed. As an example, the second insulating layer 116, the pixel-defining layer 118, and/or the touch line TL may be separated from each other at respective interfaces therebetween. The upper layer may include, for example, the pixel-defining layer 118, the spacer 119, and the encapsulation layer TFE. The upper layer, for example, the pixel-defining layer 118, the spacer 119, and the encapsulation layer TFE may be defined as a first adjacent portion 600. The lower layer may include, for example, the second insulating layer 116, the first insulating layer 115, the inorganic insulating layer IL, and the substrate 100. The lower layer, for example, the second insulating layer 116, the first insulating layer 115, the inorganic insulating layer IL, and the substrate 100 may be defined as a bent portion 700.

Similarly to FIG. 7, the bent portion 700 may be bent under the first adjacent portion 600 and spaced apart from the first adjacent portion 600. That is, the bent portion 700 may be configured to start to bend under the first adjacent portion 600. In this case, the first adjacent portion 600 may not be bent. Since the first adjacent portion 600 is connected to the optical functional layer OFL attached to the cover window CW, and the touch sensor layer TSL attached to the optical functional layer OFL, the first adjacent portion 600 may be supported by the cover window CW without being bent.

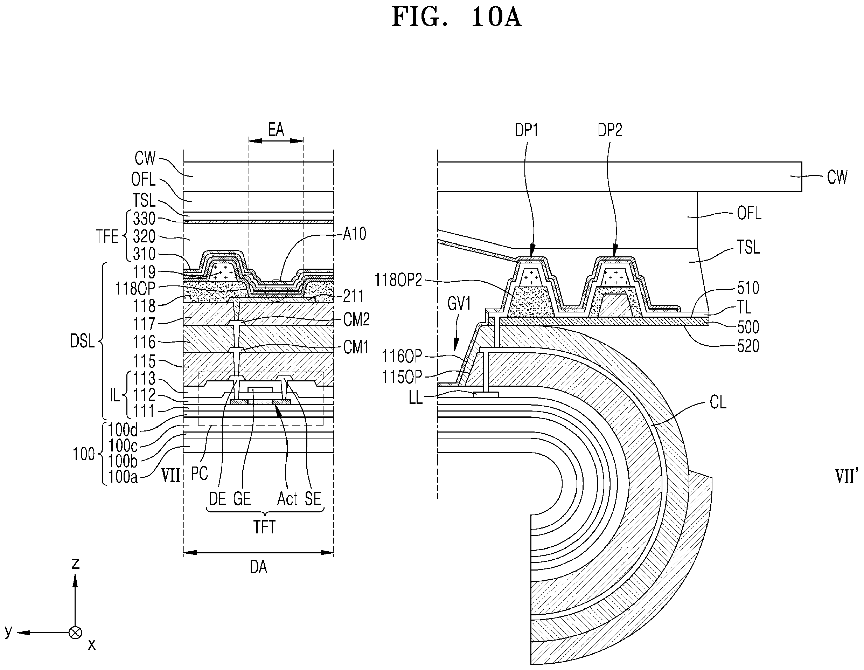

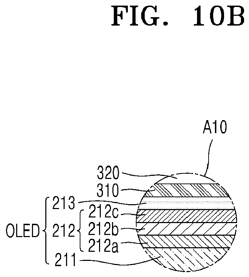

Referring to FIG. 10, in an embodiment, similarly to FIG. 7, the separation layer 500 may be in contact with and connected to the first adjacent portion 600 and be separated from the bent portion 700. In this case, in an embodiment, the touch line TL may continuously extend along side surfaces and an upper surface of the first dam portion DP1 and/or the second dam portion DP2 to extend to the end of the separation layer 500. That is, the touch line TL may be formed on the pattern portions of the pixel-defining layer 118 and the spacer 119, and under the encapsulation layer TFE, in the first adjacent area AA1. A portion of the touch line TL may not be covered by the encapsulation layer TFE to define an exposed portion of the touch line TL which is exposed outside of the encapsulation layer TFE. Accordingly, the touch line TL may be electrically connected to the touch sensor layer TSL at a portion of the touch line TL which is not covered by the encapsulation layer TFE. In addition, the touch line TL may be electrically connected to the connection line CL through a contact hole passing through the separation layer 500 and the second insulating layer 116.

In an embodiment, the touch line TL may include the same material as a material of the opposite electrode 213. In other words, the touch line TL may be formed by the same process as a process of forming the opposite electrode 213, and may therefore be in a same layer as the opposite electrode 213 (e.g., respective patterns or portions of a same conductive material layer).

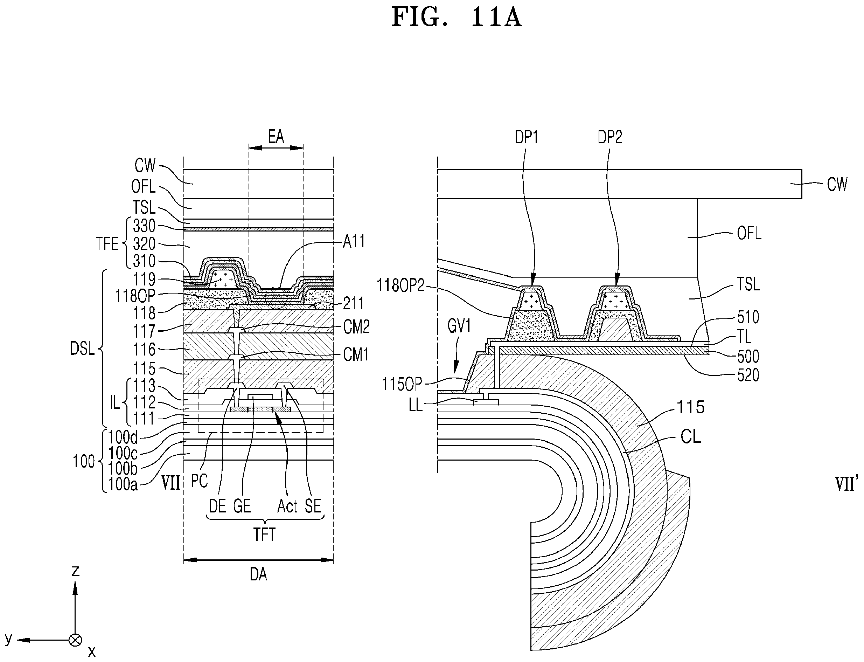

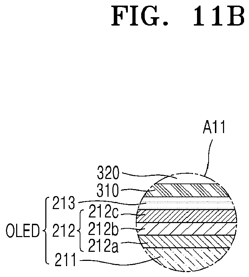

Referring to FIG. 11, in an embodiment, the first insulating layer 115 may be disposed on the portion of the inorganic insulating layer IL which is in the peripheral area PA. The first insulating layer 115 may include a first opening 115OP exposing the upper surface of the inorganic insulating layer IL, specifically, the interlayer insulating layer 113, to outside the first insulating layer 115 at the first groove GV1. Since the first insulating layer 115 is disconnected at the first opening 115OP, a penetration path of oxygen and/or moisture through the first insulating layer 115, such as in a direction between the display area DA and the peripheral area PA, may be blocked.

In an embodiment, the connection line CL may be disposed between the first insulating layer 115 and the interlayer insulating layer 113. The connection line CL may be disposed on the interlayer insulating layer 113 and covered by the first insulating layer 115. The connection line CL may extend from the first adjacent area AA1 to the pad area PDA, through the bent area BA. The connection line CL may be configured to transfer at least one of a scan signal, a data signal, and a power voltage.

In an embodiment, the connection line CL may be disposed on the same layer as a layer on which the source electrode SE or the drain electrode DE is disposed, and may include the same material as a material of the source electrode SE or the drain electrode DE. In other words, the connection line CL may be formed by the same process as a process of forming the source electrode SE or the drain electrode DE, such as to be respective portions of a same conductive material layer.

The connection line CL may be connected to a lower line LL through a contact hole arranged in the first adjacent area AA1, for example, a contact hole passing through the interlayer insulating layer 113. In an embodiment, the lower line LL may be disposed on the first gate insulating layer 112. The lower line LL may be disposed on the same layer as a layer on which the gate electrode GE is disposed and may include the same material as a material of the gate electrode GE. In other words, the lower line LL may be formed by the same process as a process of forming the gate electrode GE, such as to be respective portions of a same conductive material layer. The lower line LL may extend to the display area DA and be configured to transfer at least one of a scan signal, a data signal, and a power voltage between the display area DA and the adjacent area AA.

A pattern portion of the pixel-defining layer 118 may be disposed on the first insulating layer 115, in the first adjacent area AA1. Similarly to that described above, the first dam portion DP1 may be arranged closer to the first groove GV1 than the second dam portion DP2, in the first adjacent area AA1, to surround the display area DA. In an embodiment, the first dam portion DP1 may include patterns portions of the pixel-defining layer 118 and the spacer 119. In other words, the first dam portion DP1 may be defined by and in a same layer as the pixel-defining layer 118 and the spacer 119.

In addition, a second dam portion DP2 may be arranged in the first adjacent area AA1 to surround the display area DA in a plan view. The second dam portion DP2 may be arranged to surround the first dam portion DP1 in the plan view. In an embodiment, the second dam portion DP2 may include pattern portions of the pixel-defining layer 118 and the spacer 119. In addition, though it is shown in FIG. 11 that the second dam portion DP2 is arranged to surround the first dam portion DP1, it may be understood that the second dam portion DP2 may not be arranged selectively. Hereinafter, the case where the second dam portion DP2 is arranged is mainly described.

The encapsulation layer TFE may be disposed to cover the first groove GV1, the first dam portion DP1, and the second dam portion DP2. The encapsulation layer TFE may include at least one inorganic encapsulation layer and at least one organic encapsulation layer. In an embodiment, the encapsulation layer TFE may include the first inorganic encapsulation layer 310, the organic encapsulation layer 320, and the second inorganic encapsulation layer 330 that are sequentially stacked.

The separation layer 500 may be disposed between the first insulating layer 115 and pattern portions of the pixel-defining layer 118 in the first adjacent area AA1. In an embodiment, as shown in FIG. 4, the separation layer 500 may overlap the first adjacent area AA1 in a plan view. In addition, the separation layer 500 may define a portion of the boundary of the first adjacent area AA1. In the first adjacent area AA1, the separation layer 500 overlap the first dam portion DP1 and the second dam portion DP2. In addition, a portion of the separation layer 500, a portion of the separation layer 500 adjacent to the end of the first adjacent area AA1 which is furthest from the display area DA may not be covered by the encapsulation layer TFE to define an exposed portion of the separation layer 500.

The touch line TL may be disposed on the separation layer 500. The touch line TL may continuously extend under the first dam portion DP1 and the second dam portion DP2 to extend to the end of the separation layer 500. In addition, a portion of the touch line TL which is adjacent to the end of the first adjacent area AA1 may not be covered by the encapsulation layer TFE. Accordingly, the touch line TL may be electrically connected to the touch sensor layer TSL at the exposed portion of the touch line TL which is not covered by the encapsulation layer TFE. In addition, the touch line TL may be electrically connected to the connection line CL through a contact hole passing through the separation layer 500 and the first insulating layer 115.

In an embodiment, the touch line TL may be disposed on the same layer as a layer on which the first connection electrode CM1 is disposed and may include the same material as a material of the first connection electrode CM1. In other words, the touch line TL may be formed by the same process as a process of forming the first connection electrode CM1, so as to be respective portions of a same material layer. However, the embodiment is not limited thereto and the touch line TL may be disposed on the same layer as a layer on which the second connection electrode CM2 is disposed and may include the same material as a material of the second connection electrode CM2. In other words, the touch line TL may be formed by the same process as a process of forming the second connection electrode CM2. Alternatively, similarly to that described with reference to FIG. 10, the touch line TL may be disposed on the same layer as a layer on which the opposite electrode 213 is disposed and may include the same material as a material of the opposite electrode 213. In other words, the touch line TL may be formed by the same process as a process of forming the opposite electrode 213.

In an embodiment, the first surface 510 of the separation layer 500 may contact the touch line TL and/or the pixel-defining layer 118, and the second surface 520 may contact the first insulating layer 115.

In an embodiment, the first surface 510 and/or the second surface 520 may be separated from a contacting layer. Hereinafter, for convenience of description, the case where the second surface 520 is separated from a contacting layer at an interface between the second surface 520 and the contacting layer, for example, the first insulating layer 115 is mainly described. However, the embodiment is not limited thereto, and similarly to FIG. 8, it may be understood that the first surface 510 may be separated from a contacting layer.

The second surface 520 may be separated from the first insulating layer 115. This may be implemented by, for example, irradiating an ultraviolet ray or applying heat. In this case, the first surface 510 may be in contact with and connected to the touch line TL and/or the pixel-defining layer 118. Accordingly, the display panel 10 may be separated into an upper layer and a lower layer around (or with respect to) the separation layer 500 in the first adjacent area AA1. The upper layer may include, for example, pattern portions of the pixel-defining layer 118, the spacer 119, and the encapsulation layer TFE, on the separation layer 500. The upper layer, for example, the pixel-defining layer 118, the spacer 119, and the encapsulation layer TFE together with each other on the separation layer 500 may be defined as a first adjacent portion 600. The lower layer may include, for example, pattern portion of the first insulating layer 115, the inorganic insulating layer IL, and the substrate 100 together with each other under the separation layer 500. The lower layer, for example, the first insulating layer 115, the inorganic insulating layer IL, and the substrate 100 under the separation layer 500 may be defined as a bent portion 700.

Since the second surface 520 of the separation layer 500 is separated from the first insulating layer 115, the bent portion 700 may be bent under the separation layer 500 and spaced apart from the first insulating layer 115 as shown in FIG. 11. That is, the bent portion 700 may be configured to start to bend under the first adjacent portion 600. In this case, the first adjacent portion 600 may not be bent. Since the first adjacent portion 600 is connected to the optical functional layer OFL attached to the cover window CW, and the touch sensor layer TSL attached to the optical functional layer OFL, the first adjacent portion 600 may be supported by the cover window CW without being bent.

In addition, as shown in FIG. 11, the bent portion 700 may be disposed under the first adjacent portion 600 to overlap the first adjacent portion 600 in a plan view while the bent portion 700 is bent. In a plan view, the bent portion 700 may be arranged inside the boundary or planar area of the first adjacent portion 600. In other words, the bent portion 700 may overlap the pattern portions of the pixel-defining layer 118, the spacer 119, and the encapsulation layer TFE, particularly, the first inorganic encapsulation layer 310 and the second inorganic encapsulation layer 330 constituting the first adjacent portion 600. The bent portion 700 may overlap the first dam portion DP1 and the second dam portion DP2. In addition, the connection line CL forming the bent portion 700 may be also bent under the first adjacent portion 600 to overlap the first adjacent portion 600. As an example, the connection line CL may overlap the encapsulation layer TFE and be bent under the encapsulation layer TFE.

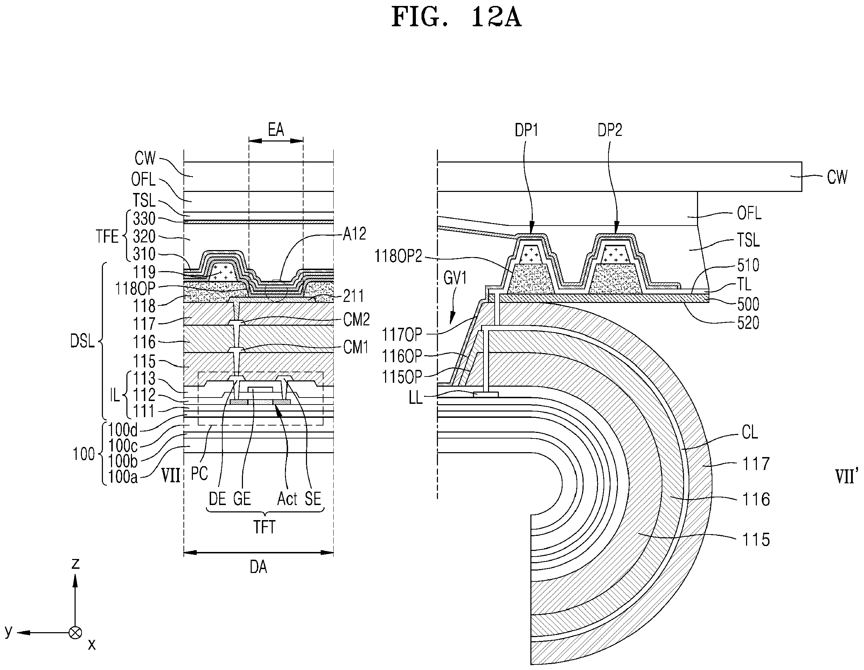

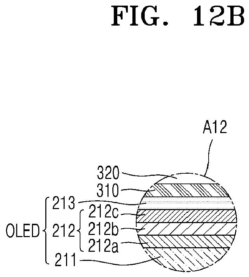

Referring to FIG. 12, in an embodiment, the first insulating layer 115 may be disposed on the inorganic insulating layer IL in the peripheral area PA. The first insulating layer 115 may include or define a first opening 115OP exposing the upper surface of the inorganic insulating layer IL, specifically, the interlayer insulating layer 113. Since the first insulating layer 115 is separated around the first opening 115OP, a penetration path of oxygen and/or moisture through the first insulating layer 115 may be blocked.

The second insulating layer 116 may be disposed on the first insulating layer 115. The second insulating layer 116 may include or define a second opening 116OP exposing the upper surface of the inorganic insulating layer IL, specifically, the interlayer insulating layer 113. In an embodiment, the second opening 116OP may be arranged to overlap the first opening 115OP. The first opening 115OP and the second opening 116OP may be continuous to form one opening exposing the upper surface of the inorganic insulating layer IL, specifically, the interlayer insulating layer 113. In other words, the first opening 115OP and the second opening 116OP may configure the first groove GV1.

The third insulating layer 117 may be disposed on the second insulating layer 116. The third insulating layer 117 may include a fourth opening 117OP exposing the upper surface of the inorganic insulating layer IL, specifically, the interlayer insulating layer 113. In an embodiment, the fourth opening 117OP may be arranged to overlap the first opening 115OP and the second opening 116OP. The fourth opening 117OP may be continuous with the first opening 115OP and the second opening 116OP to configure one opening exposing the upper surface of the inorganic insulating layer IL, specifically, the interlayer insulating layer 113.

In an embodiment, the connection line CL may be disposed between the third insulating layer 117 and the second insulating layer 116. The connection line CL may be disposed on the second insulating layer 116 and covered by the third insulating layer 117. The connection line CL may extend from the first adjacent area AA1 to the pad area PDA, through the bent area BA. The connection line CL may be configured to transfer at least one of a scan signal, a data signal, and a power voltage.

In an embodiment, the connection line CL may be disposed on the same layer as a layer on which the second connection electrode CM2 is disposed and may include the same material as a material of the second connection electrode CM2. In other words, the connection line CL may be formed by the same process as a process of forming the second connection electrode CM2.

The connection line CL may be connected to a lower line LL through a contact hole arranged in the first adjacent area AA1, for example, a contact hole passing through, the second insulating layer 116, the first insulating layer 115 and the interlayer insulating layer 113. In an embodiment, the lower line LL may be disposed on the first gate insulating layer 112. The lower line LL may be disposed on the same layer as a layer on which the gate electrode GE is disposed and may include the same material as a material of the gate electrode GE. In other words, the lower line LL may be formed by the same process as a process of forming the gate electrode GE. The lower line LL may extend to the display area DA and be configured to transfer at least one of a scan signal, a data signal, and a power voltage.

The pixel-defining layer 118 may be disposed on the third insulating layer 117. The pixel-defining layer 118 may include the third opening 118OP2 forming the first groove GV1. In an embodiment, the third opening 118OP2 may overlap the first opening 115OP, the second opening 116OP, and the fourth opening 117OP in a plan view.

Similarly to that described above, the first dam portion DP1 may be arranged adjacent to the first groove GV1 in the first adjacent area AA1 to surround the display area DA. In an embodiment, the first dam portion DP1 may include the pixel-defining layer 118 and the spacer 119. In other words, the first dam portion DP1 may be defined by the pixel-defining layer 118 and the spacer 119.

In addition, the second dam portion DP2 may be arranged in the first adjacent area AA1 to surround the display area DA. The second dam portion DP2 may be arranged to surround the first dam portion DP1. In an embodiment, the second dam portion DP2 may include the pixel-defining layer 118 and the spacer 119. In addition, though it is shown in FIG. 12 that the second dam portion DP2 is arranged to surround the first dam portion DP1, it may be understood that the second dam portion DP2 may not be arranged selectively. Hereinafter, the case where the second dam portion DP2 is arranged is mainly described.

The encapsulation layer TFE may be disposed to cover the first groove GV1, the first dam portion DP1, and the second dam portion DP2. The encapsulation layer TFE may include at least one inorganic encapsulation layer and at least one organic encapsulation layer. In an embodiment, the encapsulation layer TFE may include the first inorganic encapsulation layer 310, the organic encapsulation layer 320, and the second inorganic encapsulation layer 330 that are sequentially stacked.

The separation layer 500 may be disposed between the third insulating layer 117 and the pixel-defining layer 118 in the first adjacent area AA1. In an embodiment, as shown in FIG. 12, the separation layer 500 may overlap the first adjacent area AA1 in a plan view. In addition, the separation layer 500 may define a portion of the boundary of the first adjacent area AA1. In the first adjacent area AA1, the separation layer 500 overlap the first dam portion DP1 and the second dam portion DP2. In addition, a portion of the separation layer 500, a portion of the separation layer 500 adjacent to the end of the first adjacent area AA1 may not be covered by the encapsulation layer TFE.

The touch line TL may continuously extend on the first dam portion DP1 and the second dam portion DP2 to extend to the end of the separation layer 500. That is, the touch line TL may be formed on the pixel-defining layer 118 and the spacer 119 and under the encapsulation layer TFE, in the first adjacent area AA1. A portion of the touch line TL may not be covered by the encapsulation layer TFE. Accordingly, the touch line TL may be electrically connected to the touch sensor layer TSL through a portion of the touch line TL not covered by the encapsulation layer TFE. In addition, the touch line TL may be electrically connected to the connection line CL through a contact hole passing through the separation layer 500 and the third insulating layer 117.

In an embodiment, the touch line TL may be disposed on the same layer as a layer on which the opposite electrode 213 is disposed and may include the same material as a material of the opposite electrode 213. In other words, the touch line TL may be formed by the same process as a process of forming the opposite electrode 213.

In an embodiment, the first surface 510 of the separation layer 500 may contact the touch line TL and/or the pixel-defining layer 118, and the second surface 520 may contact the third insulating layer 117.

In an embodiment, the first surface 510 and/or the second surface 520 may be separated from a contacting layer. Hereinafter, for convenience of description, the case where the second surface 520 is separated from a contacting layer, for example, the third insulating layer 117 is mainly described. However, the embodiment is not limited thereto, and similarly to FIG. 9, it may be understood that the first surface 510 may be separated from a contacting layer.

The second surface 520 may be separated from the third insulating layer 117. This may be implemented by, for example, irradiating an ultraviolet ray or applying heat. In this case, the first surface 510 may be in contact with and connected to the touch line TL and/or the pixel-defining layer 118. Accordingly, the display panel 10 may be separated into the upper layer and the lower layer around the separation layer 500 in the first adjacent area AA1. The upper layer may include, for example, the pixel-defining layer 118, the spacer 119, and the encapsulation layer TFE on the separation layer 500. The upper layer, for example, the pixel-defining layer 118, the spacer 119, and the encapsulation layer TFE on the separation layer 500 may be defined as a first adjacent portion 600. The lower layer may include, for example, the third insulating layer 117, the second insulating layer 116, the first insulating layer 115, the inorganic insulating layer IL, and the substrate 100 under the separation layer 500. The lower layer, for example, the third insulating layer 117, the second insulating layer 116, the first insulating layer 115, the inorganic insulating layer IL, and the substrate 100 under the separation layer 500 may be defined as a bent portion 700.

Since the second surface 520 of the separation layer 500 is separated from the third insulating layer 117, the bent portion 700 may be bent under the separation layer 500 and apart from the third insulating layer 117 as shown in FIG. 12. That is, the bent portion 700 may be configured to start to bend under the first adjacent portion 600. In this case, the first adjacent portion 600 may not be bent. Since the first adjacent portion 600 is connected to the optical functional layer OFL attached to the cover window CW, and the touch sensor layer TSL attached to the optical functional layer OFL, the first adjacent portion 600 may be supported by the cover window CW without being bent.

In addition, as shown in FIG. 12, the bent portion 700 may be disposed under the first adjacent portion 600 to overlap the first adjacent portion 600 in a plan view while the bent portion 700 is bent. In a plan view, the bent portion 700 may be arranged inside the boundary or the planar area of the first adjacent portion 600. In other words, the bent portion 700 may overlap the pixel-defining layer 118, the spacer 119, and the encapsulation layer TFE, particularly, the first inorganic encapsulation layer 310 and the second inorganic encapsulation layer 330 constituting the first adjacent portion 600. The bent portion 700 may overlap the first dam portion DP1 and the second dam portion DP2. In addition, the connection line CL forming the bent portion 700 may be also bent under the first adjacent portion 600 to overlap the first adjacent portion 600. As an example, the connection line CL may overlap the encapsulation layer TFE and be bent under the encapsulation layer TFE.

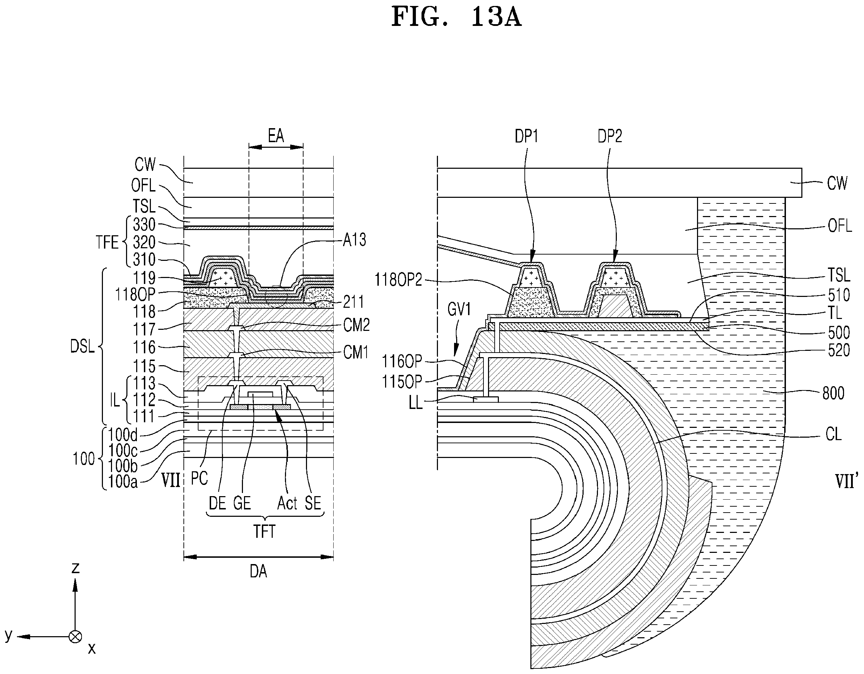

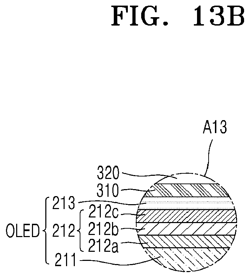

Referring to FIG. 13, in an embodiment, a protector 800 may be disposed to fill a separation space between the first adjacent portion 600 and the bent portion 700, at the end portion of the display apparatus 1 (or the display panel 10) which is bent at the bent area BA. The protector 800 may be arranged in the bent area BA to cover the bent portion 700. In addition, the protector 800 may be arranged to cover the lateral surfaces of the first adjacent portion 600, the touch sensor layer TSL, and the optical functional layer OFL which are exposed to outside at the end portion. The protector 800 may be configured to alleviate stress applied to the bent portion 700. In addition, the protector 800 may prevent display panel 10, the touch sensor layer TSL, and the optical functional layer OFL from being moisturized.

In an embodiment, the protector 800 may be formed or provided by coating resin. Alternatively, in another embodiment, the protector 800 may be formed or provided by forming a space in which the protector 800 is to be formed using a mold frame, and injecting resin in the formed space.

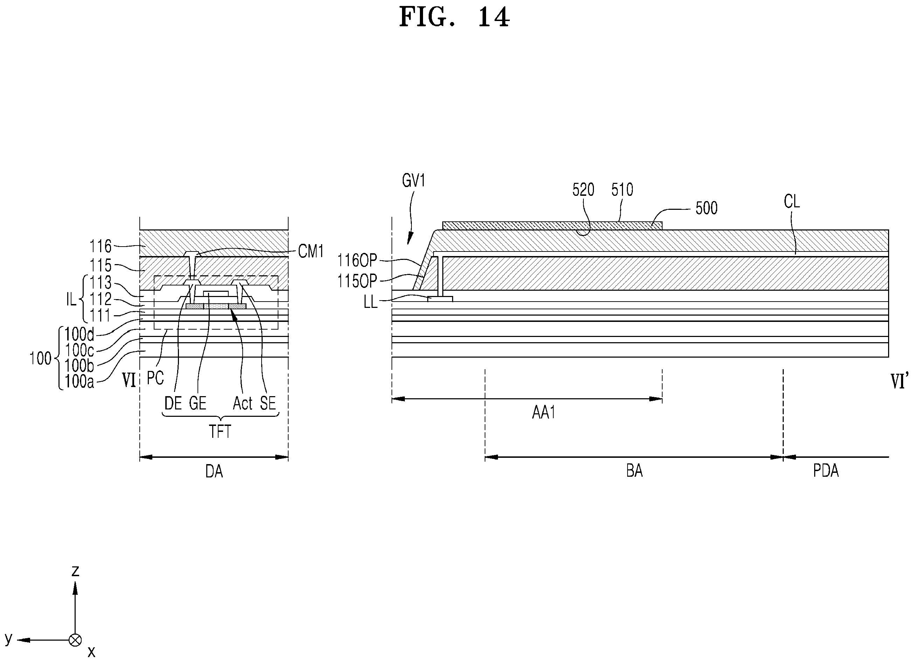

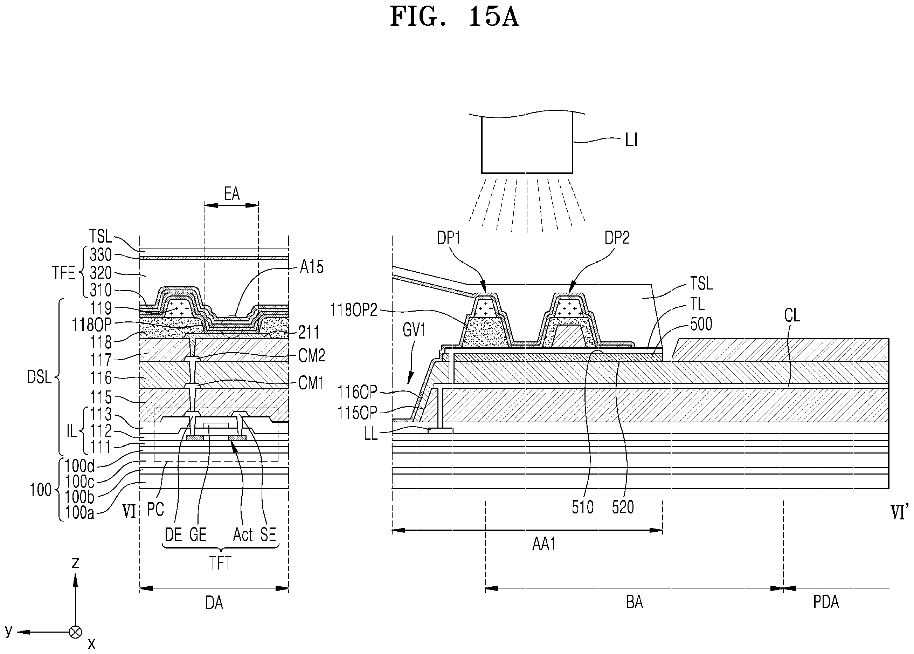

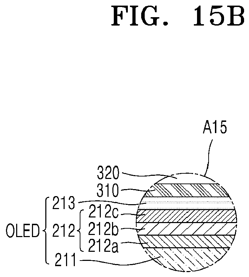

FIG. 14 is a schematic cross-sectional view of a method of manufacturing (or providing) a display apparatus 1. FIGS. 15A, 16A and 17A are schematic cross-sectional views of the method of manufacturing a display apparatus 1, and FIGS. 15B, 16B and 17B are enlarged cross-sectional views of areas A15, A16 and A17 of FIGS. 15A, 16A and 17A, respectively, according to an embodiment. Hereinafter, FIG. 15, FIG. 16 and FIG. 17 may refer to FIGS. 15A and 15B, FIGS. 16A and 16B, and FIGS. 17A and 17B, respectively together.. Hereinafter, for convenience of description, a method of manufacturing the display apparatus 1 described with reference to FIGS. 6 and 7 is mainly described below.

Referring to FIG. 14, the substrate 100, the inorganic insulating layer IL on the substrate 100, and the first insulating layer 115 and the second insulating layer 116 on the inorganic insulating layer IL may be disposed. In this case, the substrate 100 may include the display area DA and the peripheral area PA which surrounds at least a portion of the display area DA. The peripheral area PA may include the adjacent area AA, the pad area PDA, and the bent area BA, where the adjacent area AA surrounds the display area DA, the pad area PDA is arranged on one side of the adjacent area AA, and the bent area BA is arranged between the pad area PDA and the adjacent area AA.

The adjacent area AA may extend along sides of the display area DA to surround the display area DA. As an example, in the case where the display area DA is formed (or provided) in a quadrangular shape in a plan view, the adjacent area AA may include a first adjacent area AA1, a second adjacent area AA2, a third adjacent area AA3, and a fourth adjacent area AA4 respectively extending along the boundary of the display area DA for together surrounding the sides of the display area DA.

The pad area PDA may be arranged outside the display area DA, for example, outside the first adjacent area AA1. In an embodiment, the pad area PDA may be arranged farther away from the display area DA than the bent area BA.

The bent area BA may be arranged between the display area DA and the pad area PDA. In addition, the bent area BA may be arranged between the first adjacent area AA1 and the pad area PDA. The bent area BA may be a region in which the substrate 100 and various layers or components thereon are bent together with each other. In an embodiment, at least a portion of the bent area BA may overlap the first adjacent area AA1 in a plan view.

In an embodiment, the connection line CL may be disposed between the first insulating layer 115 and the second insulating layer 116. The connection line CL may be disposed on the first insulating layer 115 and covered by the second insulating layer 116. The connection line CL may extend from the first adjacent area AA1 to the pad area PDA through the bent area BA. The connection line CL may be configured to transfer at least one of a scan signal, a data signal, and a power voltage.

In an embodiment, the connection line CL may be disposed on the same layer as a layer on which the first connection electrode CM1 is disposed and may include the same material as a material of the first connection electrode CM1. In other words, the connection line CL may be formed by the same process as a process of forming the first connection electrode CM1.

In an embodiment, the separation layer 500 may be arranged in the first adjacent area AA1. Although the separation layer 500 may be disposed on the second insulating layer 116 as shown in FIG. 14, the embodiment is not limited thereto. It may be understood that in the case where the second insulating layer 116 is not stacked in the first adjacent area AA1, the separation layer 500 may be disposed on the first insulating layer 115. Alternatively, in the case where the third insulating layer 117 is stacked in the first adjacent area AA1, the separation layer 500 may be disposed on the third insulating layer 117. Hereinafter, for convenience of description, the case of FIG. 14 is mainly described.

The separation layer 500 may be arranged to overlap the first adjacent area AA1 in a plan view. In addition, the separation layer 500 may defined a portion of the boundary or edge of the first adjacent area AA1. The separation layer 500 may be formed by, for example, at least one of chemical vapor deposition, sputtering, inkjet coating, and coating. Through this process, the separation layer 500 may be formed as a thin layer to have a thickness of about tens of nanometers (nm) to about 1 micrometer (µm), preferably of about 100 nanometer (nm) to about 1 micrometer (µm).

In an embodiment, the separation layer 500 may include an organic layer including a polymer-based material and/or an inorganic layer. The polymer-based material may include acryl-based resin, urethane-based resin, and the like. In another embodiment, the separation layer 500 may include polyimide, epoxy-based resin, silicon oxide (SiOₓ), silicon nitride (SiNₓ), and the like.

Referring to FIG. 14, various insulating layers may be provided to include a disconnection corresponding to a boundary between the display area DA and the first adjacent area AA1. The disconnection may correspond to a groove in the first adjacent area AA1, as shown in FIG. 14A. A sidewall of a disconnected insulating layer may define a portion of the groove.

Referring to FIG. 15, the touch line TL may be disposed on the separation layer 500. The touch line TL may extend to the end of the separation layer 500. In addition, the touch line TL may be electrically connected to the connection line CL through a contact hole passing through the separation layer 500 and the second insulating layer 116. The contact hole may be an enclosed opening defined by portions (e.g., solid portions) of the separation layer 500 and the second insulating layer 116.

In an embodiment, the touch line TL may be disposed on the same layer as a layer on which the second connection electrode CM2 is disposed and may include the same material as a material of the second connection electrode CM2. In other words, the touch line TL may be formed by the same process as a process of forming the second connection electrode CM2.

Pattern portions of the third insulating layer 117, the pixel-defining layer 118 and the spacer 119 may be arranged in the peripheral area PA to be on the separation layer 500 and the touch line TL. The pattern portions of a same material layer may be spaced apart from each other along the separation layer 500 and the touch line TL. In this case, as described above, the pattern portions of the third insulating layer 117, the pixel-defining layer 118 and the spacer 119 may constitute various thickness portions of the first dam portion DP1 and the second dam portion DP2.

In addition, the encapsulation layer TFE may be arranged to cover the first dam portion DP1 and the second dam portion DP2. The encapsulation layer TFE may include at least one inorganic encapsulation layer and at least one organic encapsulation layer. In an embodiment, the encapsulation layer TFE may include the first inorganic encapsulation layer 310, the organic encapsulation layer 320, and the second inorganic encapsulation layer 330 that are sequentially stacked. In this case, the encapsulation layer TFE may expose at least a portion of the touch line TL to outside the encapsulation layer TFE. The exposed portion of the touch line TL may be electrically connected to the touch sensor layer TSL stacked on the encapsulation layer TFE.

Referring to FIG. 15, a contacting layer relative to the separation layer 500 may be the touch line TL or the second insulating layer 116. In the method, the separation layer 500 may be separated from the contacting layer. As an example, at least one of the first surface 510 and the second surface 520 of the separation layer 500 may be separated from a contacting layer. Hereinafter, the case where the second surface 520 of the separation layer 500 is separated from a contacting layer is mainly described.

In an embodiment, an ultraviolet ray may be irradiated to the separation layer 500, such as from a light irradiator LI. An ultraviolet ray may have a wavelength of, for example, about 385 nm to about 405 nm. Accordingly, an attachment or contact between the second surface 520 of the separation layer 500 and the contacting layer may be reduced and/or removed such that the separation layer 500 may be separated from the contacting layer, for example, the second insulating layer 116. In another embodiment, reducing contact may include applying heat to the separation layer 500. As an example, heat of about 80 degrees Celsius (°C to about 120 °C may be applied to the separation layer 500 to reduce or remove contact at an interface between the separation layer 500 and the contacting layer, and the second surface 520 of the separation layer 500 may be separated from the contacting layer, for example, the second insulating layer 116. That is, a layer which is separable from a contacting layer may be a light-irradiated layer or a heated layer having a reduced contact with the contacting layer.

In addition, though not shown in the drawing, in an embodiment, it will be understood that the separation layer 500 may be removed as described with reference to FIG. 9.

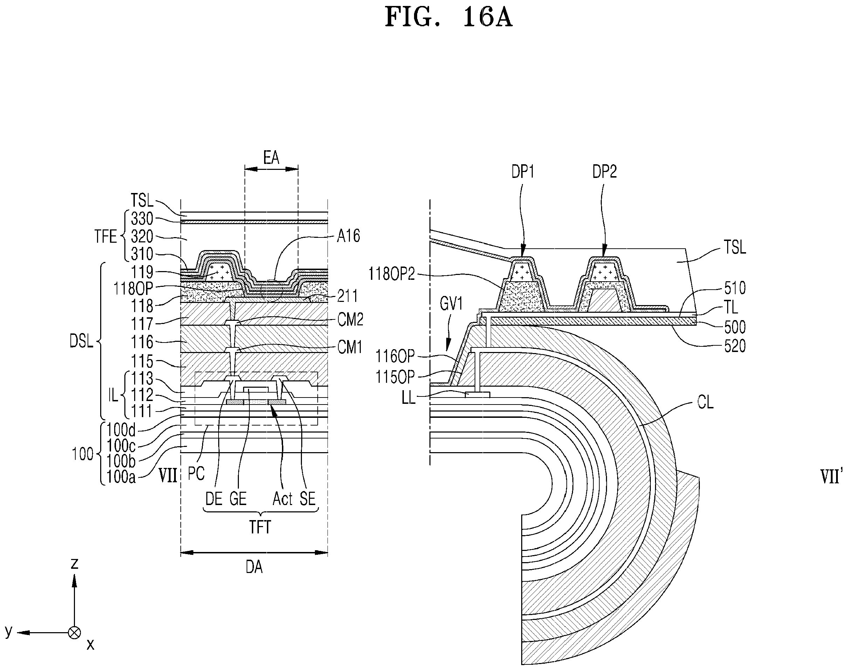

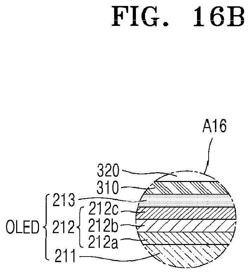

Referring to FIG. 16, then, the bent portion 700 may bent to be disposed under the separation layer 500. In this case, the bent portion 700 may be spaced apart from the separation layer 500 and the first adjacent portion 600, along the thickness direction. That is, the bent portion 700 may be configured to start to bend under the first adjacent portion 600. In this case, the first adjacent portion 600 may not be bent and remain coplanar with various patterns or layers in the display area DA. Accordingly, the bent portion 700 may overlap the first adjacent portion 600 in a plan view. In addition, the bent portion 700 may be arranged inside the boundary or planar area of the first adjacent portion 600 in a plan view. In other words, the bent portion 700 may overlap the pattern portions of the third insulating layer 117, the pixel-defining layer 118, the spacer 119, and the encapsulation layer TFE, particularly, the first inorganic encapsulation layer 310 and the second inorganic encapsulation layer 330 constituting the first adjacent portion 600. The bent portion 700 may overlap the first dam portion DP1 and the second dam portion DP2. In addition, the connection line CL forming the bent portion 700 may be also bent to be disposed under the first adjacent portion 600 and overlap the first adjacent portion 600. As an example, the connection line CL may overlap the encapsulation layer TFE and be bent under the encapsulation layer TFE.

According to an embodiment, since bending of the bent portion 700 is configured to start at a position under the first adjacent portion 600, the planar area of the non-display area in the plane defined by the x axis and the y directions due to the bending may be reduced. Specifically, in a conventional display device where the bent portion 700 is fixedly arranged with the first adjacent portion 600 and bending starts from the outer side of the second dam portion DP2, the planar area of the non-display area may be defined up to as much as a bending curvature. According to one or more embodiment, since bending does not start in the outer side of the second dam portion DP2 but may start under the flat adjacent portion (e.g., the first adjacent portion 600), the planar area of the non-display area which is defined by the flat adjacent portion and viewable along the z direction may be reduced.

Referring to FIG. 16, a display panel 10 may include layers from the substrate 100 to the encapsulation layer TFE, inclusive. The touch sensor layer TSL may be provided on the display panel 10.

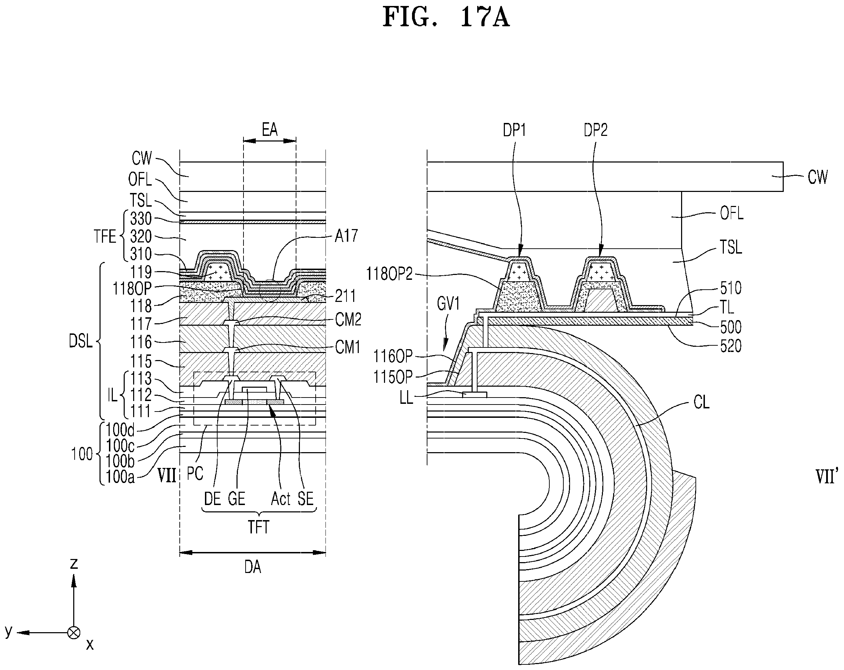

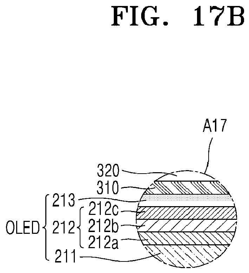

Referring to FIG. 17, then, the optical functional layer OFL may be further disposed on the touch sensor layer TSL. The cover window CW may be disposed on the optical functional layer OFL. Although the case where the display panel 10 is bent and the optical functional layer OFL and the cover window CW are attached is mainly described, the optical functional layer OFL and the cover window CW are attached first and the display panel 10 may be bent in another embodiment.

According to embodiments, the display apparatus 1 with a reduced planar area of the peripheral area PA viewable from outside the display apparatus 1 and a method of manufacturing (or providing) the display apparatus 1 may be implemented.

Effects of the present invention are not limited to the above mentioned effects and other effects not mentioned may be clearly understood by those of ordinary skill in the art from the following claims.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a display panel (10) including a display area (DA) and a bending area (BA) which is spaced apart from the display area (DA) and at which the display panel (10) is bendable to define a bent portion (700); and
a cover window (CW) which is in the bending area (BA) and covers the display panel (10),
wherein the display panel (10) in a bent state includes an adjacent portion (600) of the display panel (10) which is closer to the cover window (CW) than the bent portion (700), overlaps the bent portion (700) and is unbent.

2. The display apparatus (1) of claim 1, wherein the display panel (10) in the bent state further includes:
the bent portion (700) under the adjacent portion (600) and further from the cover window (CW) than the adjacent portion (600); and/or
an entirety of the bent portion (700) within a planar area of the adjacent portion (600); and/or
the adjacent portion (600) separated from the bent portion (700) along a thickness direction (Z).

3. The display apparatus (1) of claim 1 or 2, further comprising a protector (800), wherein the display panel (10) in the bent state defines a separation space between the adjacent portion (600) and the bent portion (700), and the protector (800) is arranged in the separation space.

4. The display apparatus (1) of any one of the preceding claims, further comprising a separation layer (500) between the adjacent portion (600) and the bent portion (700) along a thickness direction (Z).

5. The display apparatus (1) of claim 4, wherein the display panel (10) in the bent state includes:
the separation layer (500) in contact with the adjacent portion (600) and spaced apart from the bent portion (700); or
the separation layer (500) in contact with the bent portion (700) and spaced apart from the adjacent portion (600).

6. The display apparatus (1) of claim 4 or 5, wherein the display panel (10) further includes:
a display element in the display area (DA), the display element including a pixel electrode (211) and an opposite electrode (213);
a thin-film transistor (TFT) connected to the display element;
an insulating layer (IL) covering the thin-film transistor (TFT);
a pixel-defining layer (118) on the insulating layer (IL); and
an encapsulation layer (300) on the pixel-defining layer (118),
wherein
the adjacent portion (600) includes the pixel-defining layer (118) and the encapsulation layer (300) on the separation layer (500), and
the bent portion (700) includes the insulating layer (IL) under the separation layer (500), and
the display panel (10) in the bent state includes the insulating layer (IL) of the bent portion (700) spaced apart from the separation layer (500).

7. The display apparatus (1) of claim 6, wherein the display panel (10) in the bent state includes the bent portion (700) under the encapsulation layer (300) and overlapping the encapsulation layer (300).

8. The display apparatus (1) of claim 6 or 7, wherein
the bent portion (700) further includes a connection line (CL) extending along the bent portion (700) from the display area (DA), and
the display panel (10) in the bent state further includes the connection line (CL) under the separation layer (500).

9. The display apparatus (1) of any one of claims 6 to 8, further comprising:
a touch sensor layer (TSL) between the display panel (10) and the cover window (CW), and
a touch line (TL) which is electrically connected to the touch sensor layer (TSL) and between the display panel (10) and the touch sensor layer (TSL).

10. The display apparatus (1) of claim 9, wherein
the adjacent portion (600) further includes the touch line (TL), and
the display panel (10) in the bent state further includes the touch line (TL) under the pixel-defining layer (118) and in contact with the separation layer (500); and/or
the touch line (TL) is between the encapsulation layer (300) and the pixel-defining layer (118), and
the touch line (TL) and the opposite electrode (213) are respective portions of a same material layer.

11. A method of providing a display apparatus (1), the method comprising:
providing a substrate (100) of a display panel (10), the substrate (100) including a display area (DA) and a bending area (BA) which is spaced apart from the display area (DA) and at which the substrate (100) is bendable to define a bent portion (700) of the display apparatus;
providing on the substrate (100), in the bending area (BA):
a separation layer (500) on the substrate (100), the separation layer (500) including a first surface (510) and a second surface (520) which is opposite to the first surface (510) and closer to the substrate (100) than the first surface (510),
a contacting layer of the display panel (10) which is in contact with a surface among the first surface (510) or the second surface (520) of the separation layer (500), and
an encapsulation layer (300) of the display panel (10) which covers the separation layer (500);
reducing contact between the contacting layer of the display panel (10) and the surface of the separation layer (500); and
bending the substrate (100) to define the bent portion (700).

12. The method of claim 11, wherein
the bending of the substrate (100) further defines an adjacent portion (600) of the display apparatus (1) which corresponds to the separation layer (500), is further from the substrate (100) than the bent portion (700), overlaps the bent portion (700) and is unbent, and
the substrate (100) in a bent state includes the bent portion (700) under the adjacent portion (600).

13. The method of claim 12, wherein
the adjacent portion (600) includes the encapsulation layer (300), and
the substrate (100) in the bent state further includes the bent portion (700) under the encapsulation layer (300) to overlap the encapsulation layer (300).

14. The method of claim 12 or 13, wherein the substrate (100) in the bent state:
further includes an entirety of the bent portion (700) within a planar area of the adjacent portion (600) which is unbent; and/or
further defines a separation space between the adjacent portion (600) and the bent portion (700), and
the method further comprising providing a protector (800) in the separation space.

15. The method of any one of claims 11 to 14, wherein the reducing the contact includes:
irradiating an ultraviolet ray to the separation layer (500); and/or
applying heat to the separation layer (500).

16. The method of any one of claims 11 to 15, wherein the bending of the substrate (100) defines a curvature of the bent portion (700) which starts at a location corresponding to the separation layer (500).

17. The method of any one of claims 11 to 16, further comprising providing a cover window (CW) which is in the bending area (BA) and covers the separation layer (500),
wherein
the bending of the substrate (100) further defines an adjacent portion (600) of the display apparatus (1) which is in the bending area (BA), is further from the substrate (100) than the bent portion (700), overlaps the bent portion (700) and is unbent, and
the adjacent portion (600) includes the cover window (CW).

18. The method of any one of claims 11 to 17, wherein
the bending of the substrate (100) further defines an adjacent portion (600) of the display apparatus (1) which is in the bending area (BA), is further from the substrate (100) than the bent portion (700), overlaps the bent portion (700) and is unbent;
wherein
the adjacent portion (600) includes the separation layer (500); or
the bent portion (700) includes the separation layer (500).

19. The method of any one of claims 11 to 18, wherein
the bending of the substrate (100) further defines an adjacent portion (600) of the display apparatus (1) which is in the bending area (BA), is further from the substrate (100) than the bent portion (700), overlaps the bent portion (700) and is unbent; and
wherein
each of the adjacent portion (600) and the bent portion (700) having a planar area in a plan view, and
the bending of the substrate (100) includes an entirety of the planar area of the bent portion (700) within the planar area of the adjacent portion, in the plan view.
